(19) Europäisches Patentamt
European Patent Office
Office européen des brevets

(11) **EP 2 197 014 B1**

(12) **EUROPÄISCHE PATENTSCHRIFT**

(45) Veröffentlichungstag und Bekanntmachung des Hinweises auf die Patenterteilung:
**07.09.2016   Patentblatt 2016/36**

(51) Int Cl.:
*H01J 37/04* (2006.01)     *H01J 37/09* (2006.01)
*H01J 37/147* (2006.01)    *H01J 37/302* (2006.01)
*H01J 37/317* (2006.01)    *G03F 7/20* (2006.01)

(21) Anmeldenummer: **09178753.1**

(22) Anmeldetag: **10.12.2009**

(54) **Anordnung zur Beleuchtung eines Substrats mit mehreren individuell geformten Partikelstrahlen zur hochauflösenden Lithographie von Strukturmustern**

System for exposure of a substrate with several individually shaped charged particle beams for high resolution lithography of structured patterns

Dispositif d'exposition d'un substrat avec plusieurs faisceaux de particules chargées à forme variable pour la lithographie à haute résolution de motifs structurés

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **13.12.2008   DE 102008062450**

(43) Veröffentlichungstag der Anmeldung:
**16.06.2010   Patentblatt 2010/24**

(73) Patentinhaber: **Vistec Electron Beam GmbH**
**07745 Jena (DE)**

(72) Erfinder:
• **Döring, Hans-Joachim**
  **07749 Jena (DE)**
• **Elster, Thomas**
  **07745 Jena (DE)**
• **Slodowski, Matthias**
  **07745 Jena (DE)**
• **Heinitz, Joachim**
  **07751 Isserstedt (DE)**

(74) Vertreter: **Freitag, Joachim et al**
**Patentanwälte**
**Oehmke & Kollegen**
**Neugasse 13**
**07743 Jena (DE)**

(56) Entgegenhaltungen:
**EP-A2- 1 993 118        GB-A- 2 349 737**
**US-A1- 2006 243 921**

**Beschreibung**

Die Erfindung betrifft eine Anordnung zur Beleuchtung eines Substrates mit mehreren individuell geformten steuerbaren Partikelstrahlen mit einer Partikelstrahlquelle zur Aussendung eines Partikelstrahls, einem Beleuchtungssystem zur Formung und Ablenkung des Partikelstrahls für die Beleuchtung eines ersten Aperturblendenarrays, wobei das Aperturblendenarray ein Multiformatblendenarray zur Erzeugung von separaten Partikelteilstrahlen ist, einem zweiten Multiformatblendenarray, auf das das erste Multiformatblendenarray mittels eines Kondensorlinsensystems abgebildet ist und das unter Berücksichtigung des Abbildungsmaßstabes zum ersten Multiblendenarray angepasste Blendenöffnungen aufweist, einem Multistrahldeflektorsystem zur individuellen Strahlablenkung der separaten Partikelstrahlen sowie einer wenigstens einstufigen Verkleinerungsoptik zur verkleinerten Abbildung der von dem zweiten Aperturblendenarray durchgelassenen Partikelteilstrahlen auf ein Substrat.

Die Erfindung findet vorzugsweise in der Elektronenstrahllithographie Anwendung, insbesondere in der Halbleiterindustrie zur Direktstrukturierung von Wafern und Masken für die Photolithografie.

Mit jedem Technologieknoten, also ca. alle 3 Jahre, verdoppelt sich in der Halbleiterindustrie die Anzahl der Strukturen auf gleicher Bauelementefläche. Die bildgebenden Verfahren zur Strukturerzeugung auf den Masken bzw. Verfahren zur Direktstrukturierung von Wafern benötigen deshalb eine immer größere Schreibzeit. Ein weiterer Grund für den Produktivitätsverlust von hochauflösenden Elektronenstrahlschreibern bei der Highend-Maskenherstellung ist bedingt durch die immer stärkere Vorverzerrung der Maskenstruktur (optical proximity correktion - OPC), um die Strukturauflösung hochproduktiver Scannerobjektive, deren Auflösung bekanntermaßen beugungsbegrenzt ist, zu verbessern.

Die Forderung der Halbleiterindustrie nach Kostensenkung durch Reduzierung der Schreibzeit bei der Highend-Maskenherstellung sowie bei der Direktbelichtung von Wafern lässt sich mit den derzeit verfügbaren Einzelstrahlschreibtechnologien nicht erfüllen.

Es wird deshalb zunehmend zu alternativen Multistrahlkonzepten übergegangen. Multiformstrahl-Lithographiekonzepte lassen eine deutliche Durchsatzsteigerung insbesondere für sehr hohe Integrationsniveaus (< 65 nm Technologie) erwarten. Dem Konzept liegt die Idee zugrunde, mehrere Partikelstrahlen, die in Form und Größe einstellbar sowie in ihrer Position auf dem Substrat steuerbar sind, gleichzeitig auf dem Substrat verfügbar zu machen.

Im Stand der Technik sind dafür zwei prinzipielle Wege zur Steigerung des Durchsatzes von Partikelstrahl-Lithographiesystemen bekannt geworden.

Auf der einen Seite sind dies Lösungen für massiv parallel arbeitende Multistrahlsysteme, die große Arrays ($10^4...10^7$ Strahlen) von fein fokussierten in Form und Größe festen Partikelstrahlbündeln verwenden (Elektronenstrahl-Pixel), die im Wesentlichen kollektiv über das zu belichtende Substrat geführt werden (Tischbewegung und Ablenksysteme) und dabei entsprechend dem zu belichtenden Muster rechtzeitig ein- bzw. ausgeschaltet werden. Vertreter dieses Pixelkonzepts sind z.B. MAPPER (siehe C. Klein et al., "Projection maskless lithography (PML2): proof-of-concept setup and first experimental results", Proceedings SPIE Advanced Lithography 2008, vol. 6921-93) und PML2 (siehe E. Slot et al., "MAPPER: high throughput maskless lithography", Proceedings SPIE Advanced Lithography 2008, vol. 6921-92). Nachteile dieser Konzepte liegen in der hohen Komplexität der Strahlmodulatoren (Tausende bis Hunderttausende von Ablenksystemen/Linsen) und den hohen zu übertragenden Datenraten, da das Schaltkreis-Layout verlustfrei in einzelne Pixel zerlegt werden muss und dabei jegliche Hierarchie und Kompression verloren geht.

Die zweite Gruppe von Lösungsansätzen geht von variabel strukturierten Flächenstrahlen (auch Flächensonde genannt) aus, die benutzt werden, um gewünschte Strukturen variabel durch Projektion von verschiedenen flächigen Strahlquerschnitten auf ein Substrat zu belichten (VSB - Variable Shaped Beam).

In der US°6,703,629°B2 ist ein recht komplexes Charakterprojektionsverfahren (CP) offenbart, bei dem verschiedene Lochmasken in zwei Ebenen so aufeinander abgebildet und ggf. durch ein dazwischen befindliches Ablenksystem abgelenkt werden, dass typische wiederholt auftretende Strahlstrukturen entstehen, die dann verkleinert zur Belichtung benutzt werden. Die Nachteile dieses Verfahrens liegen in der fest gewählten Charakterblendengeometrie, wenn sie denn einmal gefertigt wurde. Ein anderes Technologieniveau, das andere Leitbahnabstände oder CP-Maße benötigt, verlangt jeweils ein neues Paar Charakterblenden. Ein weiterer Nachteil dieses Belichtungsverfahrens besteht darin, dass prinzipbedingt die Stromdichte innerhalb eines Charakters konstant ist. Eine von der Belichtungsumgebung abhängige Korrektur des Proximity-Effektes, insbesondere für einen großen Charakter, ist somit nur schwer möglich, wodurch der Nutzen bzw. die Qualität der erzeugten Strukturen beschränkt wird.

Aus der US 7,005,658 B2 ist bekannt, ein Array von Partikelstrahlen mit Hilfe einer Aperturplatte zu erzeugen, die parallel beleuchtet wird, indem eine gemeinsame Strahlquelle mittels Kondensorlinse kollimiert wird. Alle Teilstrahlen werden mit Hilfe von Korrekturlinsen und Ablenksystemen individuell so korrigiert, dass die im Verkleinerungssystem auftretende Bildfeldverzeichnung und Bildfeldwölbung verschwinden. Das so erzeugte Array von Punktstrahlen wird nun kollektiv über das zu belichtende Substrat geführt und die Teilstrahlen werden entsprechend dem gewünschten Muster rechtzeitig ein- bzw. ausgeschaltet (blanking array).

Nachteilig bei diesem Verfahren ist die große Menge an Pixeldaten, die benötigt wird, um ein vorgegebenes Muster zu belichten. Weiterhin werden eine Vielzahl von aufwändigen elektrostatischen Korrekturelementen, wie Linsenarrays und Ablenkarrays benötigt, um die Positionen und Fokussiereebenen aller Teilstrahlen im Target zu kontrollieren. Nachteilig für dieses Verfahren ist zudem, dass die Einzelstrahlen in der Targetebene von gleicher Größe sind und sich auf einem fixierten Positionsraster befinden. Um den heutigen Anforderungen an die Positionsgenauigkeit zu belichtender Strukturen (Platzierung 2...5 nm) gerecht zu werden, muss man Mehrfachbelichtungen mit kleinem Positionsversatz durchführen (sog. Graustufenbelichtung bzw. gray beaming), was bekanntlich zur Verschlechterung der Strukturkanten führt und die Produktivität verringert.

In US 5,981,962 A und US 6,175,122 B1 wird ein Elektronenstrahl-Lithographiesystem beschrieben als eine verteilte Anordnung von vielen, parallel arbeitenden, variablen Formstrahlen. Das als kompaktes Miniatursystem gedachte Konzept benutzt pro elektronenoptischem System zwei aufeinander abgebildete Lochblenden mit einem dazwischen angeordneten Ablenksystem zur Strahlquerschnittsteuerung. Ein äußeres homogenes magnetisches Feld sorgt für die fokussierte Abbildung der Blendenebenen aufeinander und auf das Target. Die Positionsablenkung im Target wird vorgeschlagen durch Bewegung des Substrattisches in einer Richtung und kollektive, zeilenweise elektrostatische Ablenkung in orthogonaler Richtung auszuführen. Jedes miniaturisierte VSB-System (Variable Shaped Beam System) soll dabei von separaten Elektronenquellen versorgt werden (sog. Emitterarray).

Nachteilig an diesem Verfahren ist eine 1:1-Abbildung der stahlformenden Blenden in die Targetebene. Die geforderte Kantenrauhigkeit von lithographierten Strukturen liegt heute für fortgeschrittene Technologien im Bereich weniger Nanometer. Die Güte der zu verwendenden Blenden müsste also noch besser sein, was technologisch sehr schwierig erscheint, insbesondere in Bezug auf die Erzeugung derart kleiner Eckenradien. Kontaminationseffekte an den Blendenkanten im praktischen Betrieb werden ebenfalls im Verhältnis 1:1 bei der Belichtung wirksam und limitieren deshalb die Güte der Strukturen bzw. die Standzeit der Blenden. Weiterhin ist der Aufwand für die Bereitstellung eines ganzen Arrays von Strahlquellen und deren individuelle Überwachung von Nachteil. Für die Einhaltung der Fokusbedingung gleichzeitig für alle Strahlbündel ist eine sehr hohe mechanische Genauigkeit erforderlich und eine sehr gute Homogenität des Magnetfeldes, was nur mit sehr großem Aufwand erreicht werden kann.

Unklar bleibt zudem, wie die Fokussierung kollektiv erfolgen soll, wenn das Target (z.B. bearbeiteter Wafer) eine unvermeidliche Restunebenheit aufweist. Schließlich stellt die kollektive Ablenkung aller Strahlen in der Targetebene eine starke Einschränkung für die Anzahl der gleichzeitig zur Belichtung nutzbaren Strahlen dar oder gibt ein festes Raster für die Strukturerzeugung vor. Das fixierte Raster der Strahlenbündel muss stets zur Deckung gebracht werden mit den notwendigen Sollpositionen der zu belichtenden Strukturen. Das hat im Falle eines sehr feinen Entwurfsrasters der Strukturen wesentliche Einschränkungen hinsichtlich Produktivität und/oder Flexibilität der Belichtungseinrichtung zur Folge.

In US 6,614,035 B2 wird ein Multistrahl-System beschrieben, dessen Funktion dem bekannten VSB-System (Einzelstrahl) sehr ähnlich sein soll. Zur Separierung mehrerer einzeln steuerbarer Strahlen im Bereich der beiden strahlformenden Blendenebenen wird vorgeschlagen, hier jeweils eine Blende anzuordnen, die das herkömmliche Leuchtfeld (Blendenöffnung) durch eingebrachte Stege in mehrere Öffnungen unterteilt. Jedes so entstehende Strahlbündel erhält vier individuelle Ablenksysteme, die in zwei Abschnitten der elektronenoptischen Säule angeordnet werden sollen und zwei unabhängige Funktionen ausführen. Die obere erste Ablenksystemstufe dient der individuellen Einstellung des Strahlquerschnittes und die zweite Ablenksystemstufe dient der Einstellung des Abstandes benachbarter Strahlenbündel in gewissen Grenzen. Die nachfolgende Verkleinerung und Positionierung des Arrays von Strahlenbündeln im unteren Teil der Abbildung erfolgt kollektiv und genau wie in einem VSB-System.

Nachteilig an diesem Konzept ist, die Ablenkung der Strahlenbündel in zwei orthogonalen Richtungen in nur einer Ebene durchzuführen, denn das gleichzeitige Ablenken in zwei orthogonalen Richtungen führt in solchen strahlnahen Ablenkanordnungen zu großen Ablenkfehlern, die die Kantenqualität und Homogenität der Ausleuchtung verschlechtern. Dies gilt auch für die Ablenksysteme zur individuellen Steuerung des gegenseitigen Strahlabstandes in einem Array von gleichzeitig individuell zu steuernden Teilstrahlen. Des Weiteren gibt es keine konkreten Vorschläge zur Vermeidung des Übersprechens (Crosstalk) zwischen den benachbarten Ablenksystemen, die auf engstem Raum strahlnah für jeden Strahl des Multistrahl-Systems angeordnet sind.

Eine weitere Schwäche des Konzepts liegt in der Verwendung von mehreren kleinen variablen Strahlquerschnitten vergleichbarer Größe für den Belichtungsprozess eines ganzen Design-Layouts. Typischerweise enthalten die zu belichtenden Layouts, auch bei fortschreitendem Integrationsgrad, nicht ausschließlich ganz kleine Strukturen, sondern auch größere. Der Produktivitätsgewinn, den man bei der Belichtung vieler kleiner Strukturen mittels eines Arrays von 4 oder 16 parallel arbeitenden Strahlen erhält, kann teilweise wieder vernichtet werden, wenn im Layout eine Reihe relativ großer Muster in ungünstigem Abstand enthalten sind.

Ferner ist aus der DE 100 20 714 A1 eine Elektronenstrahl-Belichtungsvorrichtung bekannt, bei der ebenfalls Formgebungsmittel und Ablenkelemente den Querschnitt und die Position eines auf die Probe gerichteten Elektronenstrahls beeinflussen, wobei das Formgebungsmittel den Elektronenstrahl in eine Vielzahl gleichartigen Teilstrahlen aufspaltet, die dann einzeln abgelenkt werden, um Größe und Position der Teilstrahlen zu verändern. Nachteilig an der derartig konzipierten Elektronenstrahlsäule ist die Notwendigkeit von vier Multideflektorarrays, um drei Funktionen (Formgebung, Positionierung und Ein-/Austastung) zu realisieren, wobei im weiteren Verlauf der Elektronenstrahlsäule für jedes Ablenkelement innerhalb der Blendenanordnungen zur Strahlformung eine gleiche Anzahl von Ablenkelementen zur Rückstellung der ersten Ablenkwinkel erforderlich ist. Des Weiteren hat dieses Konzept den Nachteil, dass die zu belichtenden Strukturmuster ausschließlich mit einem Array von parallel arbeitenden kleinflächigen Teilstrahlen erzeugt werden können, wodurch es an der Möglichkeit fehlt, zur weiteren Steigerung der Produktivität der Strukturerzeugung zu großflächigen oder speziell geformten Strahlstrukturierungsvarianten zu wechseln.

Der Erfindung liegt die Aufgabe zugrunde, eine neue Möglichkeit zur Beleuchtung eines Substrats mit mehreren individuell geformten steuerbaren Partikelstrahlen zu finden, die eine hochauflösende Strukturierung von Substraten mit einem hohen Substratdurchsatz gestattet, ohne dass die Flexibilität der zu beleuchtenden Strukturmuster eingeschränkt ist oder eine geforderte hohe Flexibilität der beleuchtbaren Strukturmuster den hohen Substratdurchsatz behindert.

Erfindungsgemäß wird die Aufgabe bei einer Anordnung zur Beleuchtung eines Substrates mit mehreren individuell geformten steuerbaren Partikelstrahlen gelöst mit einer Partikelstrahlquelle zur Aussendung eines Partikelstrahls, einem Beleuchtungssystem zur Formung und Ablenkung des Partikelstrahls für die Beleuchtung eines ersten Aperturblendenarrays, wobei das erste Aperturblendenarray ein Multiblendenarray zur Erzeugung von separaten Partikelteilstrahlen ist, einem zweiten Multiblendenarray, auf welches das erste Multiblendenarray mittels eines Kondensorlinsensystems abgebildet ist und das unter Berücksichtigung des Abbildungsmaßstabes zum ersten Multiblendenarray angepasste Blendenöffnungen aufweist, wobei das erste und das zweite Multiblendenarray als Multiformatblendenarrays zur Erzeugung von Partikelteilstrahlen mit unterschiedlichen Strahlquerschnitten ausgebildet sind, einem Multistrahldeflektorsystem zur individuellen Strahlablenkung der separaten Partikelstrahlen und einer wenigstens einstufigen Verkleinerungsoptik zur verkleinerten Abbildung der vom zweiten Aperturblendenarray durchgelassenen Partikelteilstrahlen auf ein Substrat, wobei dem ersten Multiformatblendenarray und dem zweiten Multiformatblendenarray mindestens drei Multistrahldeflektorarrays zur individuellen Ablenkung der Partikelteilstrahlen zugeordnet sind, von denen mindestens ein erstes Multistrahldeflektorarray zwischen dem ersten Multiformatblendenarray und dem zweiten Multiformatblendenarray angeordnet ist, um mittels einer individuellen Strahlablenkung der einzelnen Partikelteilstrahlen unterschiedliche Querschnitte der Partikelteilstrahlen nach dem zweiten Multiformatblendenarray zu erzeugen, mindestens ein zweites Multistrahldeflektorarray in der Nähe des zweiten Multiformatblendenarrays angeordnet ist, um einzelne Partikelteilstrahlen individuell in partielle Crossover abzulenken oder an einer in einem nachgeordneten Crossover angeordneten Austrittsaperturblende gezielt auszutasten, und mindestens ein drittes Multistrahldeflektorarray dem zweiten Multiformatblendenarray in einer Entfernung von 10-20 % des Abstandes zwischen Multiformatblendenarray und Crossover nachgeordnet ist, um unterschiedliche Positionen der Partikelteilstrahlen auf dem Substrat zu erzeugen.

Vorteilhaft sind die Multistrahldeflektorarrays aus zwei übereinander liegenden Deflektorchips zusammengesetzt, auf denen jeweils ein Deflektorzellenarray aus gleichen Elektrodenpaaren für die individuelle Ablenkung von einzelnen Partikelteilstrahlen in gleicher Richtung lateral zur optischen Achse vorhanden sind, wobei die Elektrodenpaare der Deflektorzellenarrays auf den zwei Deflektorchips in zueinander im Wesentlichen orthogonalen Richtungen ausgerichtet sind.

In einer bevorzugten Ausführungsform ist im Strahlverlauf des Beleuchtungssystems für den von der Partikelstrahlquelle ausgesendeten Partikelstrahl ein Beleuchtungsgruppenselektor mit nachgeordnetem Stigmator angeordnet zur Auswahl einer Beleuchtungsgruppe auf dem ersten Multiformatblendenarray.

Die Multiformatblendenarrays weisen vorteilhaft mindestens zwei große Blendenöffnungen im Bereich von 30 $\mu$m bis 200 $\mu$m Kantenlänge zur Belichtung mit großformatigem Partikelteilstrahl und mindestens eine Strahlformblendengruppe aus einer Vielzahl kleiner Blendenöffnungen im Bereich von 5 $\mu$m bis 20 $\mu$m Kantenlänge zur Belichtung mit einem Array von kleinformatigen Partikelteilstrahlen auf.

Dabei können die Multiformatblendenarrays zweckmäßig unterschiedliche Strahlformungsblendengruppen aufweisen, wobei mittels des Beleuchtungsgruppenselektors des Beleuchtungssystems eine von mehreren unterschiedlichen Strahlformungsblendengruppen des ersten Multiformatblendenarrays separat beleuchtbar sind, um verschieden dimensionierte Partikelteilstrahlen und Arrays von Partikelteilstrahlen zu erzeugen.

In einer ersten Variante sind die Multistrahldeflektorarrays zur individuellen Ablenkung der Partikelteilstrahlen vorzugsweise so angeordnet, dass das erste Multistrahldeflektorarray dem ersten Multiformatblendenarray nachgeordnet ist, das zweite Multistrahldeflektorarray dem zweiten Multiformatblendenarray vorgeordnet und das dritte Multistrahldeflektorarray dem zweiten Multiformatblendenarray nachgeordnet ist.

In einer zweiten Variante kann das erste Multistrahldeflektorarray dem zweiten Multiformatblendenarray vorgeordnet und das zweite und dritte Multistrahldeflektorarray dem zweiten Multiformatblendenarray nachgeordnet sein.

Bei einer dritten Gestaltungsform ist das erste Multistrahldeflektorarray in unmittelbarer Nähe dem ersten Multiformatblendenarray nachgeordnet, das zweite Multistrahldeflektorarray in unmittelbarer Nähe dem zweiten Multiformatblendenarray vorgeordnet und das dritte Multistrahldeflektorarray dem zweiten Multiformatblendenarray in einer Entfernung von 10...20 % des Abstandes bis zum nächsten Crossover nachgeordnet.

In einer vierten Variante kann das erste Multistrahldeflektorarray in unmittelbarer Nähe dem zweiten Multiformatblendenarray vorgeordnet, das zweite Multistrahldeflektorarray in unmittelbarer Nähe dem zweiten Multiformatblendenarray nachgeordnet und das dritte Multistrahldeflektorarray dem zweiten Multistrahldeflektorarray in einer Entfernung von 10...20% des Abstandes bis zum nächsten Crossover nachgeordnet sein.

Bei einer fünften zweckmäßigen Variante ist das erste Multistrahldeflektorarray in unmittelbarer Nähe dem ersten Multiformatblendenarray nachgeordnet, das zweite Multistrahldeflektorarray in unmittelbarer Nähe dem zweiten Multiformatblendenarray nachgeordnet und das dritte Multistrahldeflektorarray dem zweiten Multistrahldeflektorarray in einer Entfernung von 10...20 % des Abstandes bis zum nächsten Crossover nachgeordnet.

Eine sechste Variante sieht vor, dass das erste Multistrahldeflektorarray in unmittelbarer Nähe dem ersten Multiformatblendenarray nachgeordnet, das zweite Multistrahldeflektorarray in unmittelbarer Nähe dem zweiten Multiformatblendenarray vorgeordnet, das dritte Multistrahldeflektorarray als ein erstes Feinpositionierarray in unmittelbarer Nähe dem zweiten Multiformatblendenarray nachgeordnet sowie ein viertes Multistrahldeflektorarray als ein zweites Feinpositionierarray dem dritten Multistrahldeflektorarray nachgeordnet ist.

Zweckmäßig ist in allen vorgenannten Varianten zwischen dem dritten Multistrahldeflektorarray und dem auf das Substrat abbildenden Verkleinerungssystem ein mindestens zweistufiger Stigmator zur Korrektur der toleranzbedingten Verzeichnung angeordnet.

Es erweist sich als vorteilhaft, die Elektrodenpaare der Deflektorzellenarrays jedes der Multistrahldeflektorarrays auf den übereinanderliegenden Deflektorchips orthogonal zueinander anzuordnen.

Ferner weisen die Multistrahldeflektorarrays bei Verwendung einer Strahlformungsblendengruppe in einem Array vom Format (n x m) auf jedem Deflektorchip zweckmäßig ein Deflektorzellenarray mit mindestens (n+2) Zeilen und (m+2) Spalten von Deflektorzellen aus parallelen Elektrodenpaaren auf, von denen die außen liegenden Deflektorzellen ohne Spannungsbeaufschlagung sind.

Zur Kompensation des Übersprechens zwischen benachbarten Deflektorzellen des Deflektorzellenarrays sind vorteilhaft Mittel zur Spannungsberechnung und - regelung vorgesehen, in denen zur Korrekturberechnung der Ablenkspannungen innerhalb eines Deflektorzellenarrays ausschließlich die Übersprechwirkung der jeweils acht direkt benachbarten Deflektorzellen für jeden einzeln betrachteten Partikelteilstrahl berücksichtigt wird.

Dabei weisen die Multistrahldeflektorarrays vorzugsweise jeweils schnelle Pipelinestrukturen aus mehrkanaligen aktiven Bauelementen zur schnellen unabhängigen Steuerung der Strahlposition, der Querschnittsfläche und der individuellen Crossover-Position für jeden Partikelteilstrahl auf, wobei die Pipelinestrukturen zweckmäßig Multi-DA-Wandler, Demultiplexer und Mehrfach-Operationsverstärker enthalten.

Es erweist sich als zweckmäßig, eine Koppelmatrix zur Steuerung aller Multistrahldeflektorarrays vorzusehen, um eine unabhängige Steuerung der Position und Größe des Partikelteilstrahls auf dem Substrat sowie der individuellen Crossover-Position für jeden Partikelteilstrahl eines Arrays von Partikelteilstrahlen in X- und Y-Richtung zu erreichen.

Zur Erhöhung der Flexibilität der belichtbaren Strukturmuster weist mindestens das zweite Multiformatblendenarray zusätzlich spezielle Charaktere (Strukturmuster) zur Belichtung von Wiederholstrukturen auf.

Des Weiteren ist es zweckmäßig, wenn die Multiformatblendenarrays mehrere verschiedene Strahlformblendengruppen mit untereinander gleichen Blendenöffnungen oder mehrere Strahlformblendengruppen mit untereinander verschiedenen Blendenöffnungen aufweisen.

Zur Minimierung der Anzahl von Einzelbelichtungsschritten auf dem Substrat ist vorteilhaft eine vorprogrammierbare Steuereinheit zur Steuerung des Beleuchtungsgruppenselektors mit nachgeordnetem Stigmator vorhanden, um die Auswahl von Beleuchtungsgruppen auf dem ersten Multiformatblendenarrays zu optimieren.

Die Erfindung basiert auf der grundlegenden Idee, das bekannte Konzept des variablen Formstrahls (VSB-Konzept), das als Einstrahlkonzept eine relativ große Maximalfläche des Strahlquerschnitts ermöglicht, mit einem Array von variabel steuerbaren Formstrahlen mit kleiner Teilstrahlfläche zu kombinieren. Im Belichtungsprozess eines Substrats kann zwischen diesen Strahlmodulationsvarianten elektronenoptisch durch schnelle Ablenkvorgänge umgeschaltet werden. Ferner werden für die Ablenkung der variablen feinstrukturierten Formstrahlen Maßnahmen beschrieben, die das Übersprechen (Crosstalk) zwischen den separat für jeden Partikelteilstrahl vorhandenen elektrostatischen Ablenksystemen erfolgreich minimiert.

Mit der erfindungsgemäßen Lösung ist es möglich, eine Beleuchtung eines Substrats mit Partikelstrahlung zu realisieren, die eine hochauflösende Strukturierung von Substraten mit einem hohen Substratdurchsatz gestattet, ohne dass die Flexibilität der zu beleuchtenden Strukturmuster eingeschränkt ist oder eine geforderte Flexibilität der beleuchtbaren Strukturmuster einen hohen Substratdurchsatz behindert.

Die Erfindung soll nachstehend anhand von Ausführungsbeispielen näher erläutert werden. Die Zeichnungen zeigen:

Fig. 1: eine Prinzipansicht der erfindungsgemäßen Anordnung mit Darstellung ausgewählter Partikelteilstrahlen,

Fig. 2: eine Ausführungsform der Erfindung mit einer Anordnung der Multistrahldeflektorarrays für die Partikelteilstrahlen sämtlich in der Nähe des zweiten Multiformatblendenarrays,

Fig. 3: eine Ausführungsvariante von kombinierten Multiformatblendenarrays und Multistrahldeflektorarrays mit Steuerungselektronik auf einer Leiterplatte (Fig. 3a) und Schnittdarstellung einer Doppelanordnung für separate Ablenkrichtungen in x und y (Fig. 3b),

Fig. 4: eine Ausführungsform des ersten Multiformatblendenarrays (Fig. 4a) und des zweiten Multiformatblendenarrays (Fig. 4b) mit den zugeordneten Multistrahldeflektorarrays,

Fig. 5: Ausschnitt aus Fig. 4a zur Darstellung eines Multistrahldeflektorarrays mit einer Elektrodenstruktur zur Crosstalkunterdrückung,

Fig. 6: ein Prinzipschema der Datenbereitstellung zur Steuerung eines Multistrahldeflektorarrays gemäß Fig. 3a und 3b,

Fig. 7: prinzipielle Ausführungsformen von ersten (Fig. 7a) und zweiten (Fig. 7b) Multiformatblendenarrays,

Fig. 8: eine weitere Ausführungsform eines Elektronenstrahl-Lithographiegerätes mit paralleler Ausrichtung des Partikelstrahls vor dem ersten Multiformatblendenarray und einem Multistrahldeflektorarray nach dem ersten und zwei Multistrahldeflektorarrays vor und nach dem zweiten Multiformatblendenarray,

Fig. 9: eine Ausführungsform eines Elektronenstrahl-Lithographiegerätes mit telezentrischer Beleuchtung wie in Fig. 8 und vier Multistrahldeflektorarrays, wobei eines nach dem ersten Multiformatblendenarray, eines vor und zwei nach dem zweiten Multiformatblendenarray angeordnet sind.

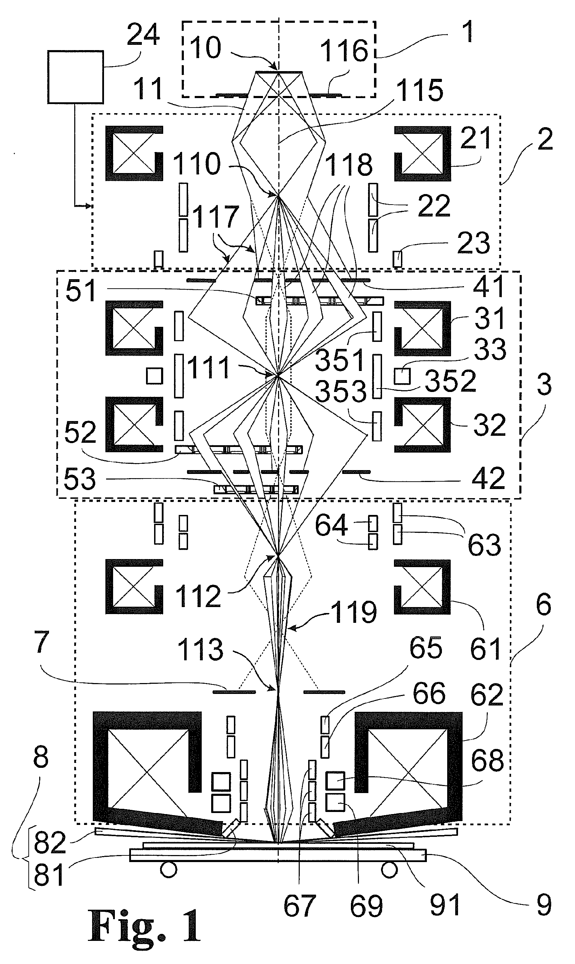

Die Anordnung zur Substratbeleuchtung mit mehreren individuellen Partikelstrahlen besteht - wie in Fig. 1 schematisch dargestellt - in ihrem Grundaufbau aus einer Partikelstrahlquelle 1, durch die eine optische Achse 115 vorgegeben wird, entlang der die gesamte Partikelstrahlsäule bis zum Substrat 91 die folgenden Komponenten aufweist: ein Beleuchtungssystem 2 zur Beleuchtung eines ersten Multiformatblendenarray 41 in wählbaren Beleuchtungsgruppen, einem Strahlmodulatorsystem 3 zur Erzeugung von mehreren Partikelteilstrahlen 118, in dem neben einem Kondensorsystem 31-32 sowohl ein Gruppenablenksystem 35 als auch ein Multideflektorsystem 5 im Zusammenwirken mit einem Multiaperturblendensystem 4 zur individuellen Ablenkung und Formung der einzelnen Partikelteilstrahlen 118 vorhanden sind. Darauf folgend sind ein Verkleinerungssystem 6 vorhanden um die vom Multiaperturblendensystem 4 transmittierten Partikelteilstrahlen 118 auf das auf einem Substrattisch 9 bewegte Substrat 91 abzubilden. Zur Beobachtung der mittels der Partikelteilstrahlen 118 auf das Substrat 91 belichteten Strukturmuster ist eine Substratüberwachungssensorik 8 unmittelbar über dem Substrattisch 9 vorhanden.

Die Erzeugung eines Arrays variabel steuerbarer Partikelteilstrahlen 118 innerhalb des Strahlmodulatorsystems 3 ist dadurch gekennzeichnet, dass in zwei Blendenebenen ein erstes Multiformatblendenarray 41 und ein zweites Multiformatblendenarray 42 angeordnet und jeweils mit äquivalenten Strahlformungsblendengruppen 45 aus einander zugeordneten Arrays kleiner Öffnungen (5...20 $\mu$m) und optional mit weiteren größeren Öffnungen (30...200 $\mu$m) ausgestattet sind. Dabei wird das erste Multiformatblendenarray 41 durch ein Kondensorsystem 31-32 (vorzugsweise im Maßstab 1:1) auf das zweite Multiformatblendenarray 42 abgebildet.

Auf ihrem Weg durch das Kondensorsystem 31-32 bis hin zum zweiten Multiformatblendenarray 42 durchlaufen die Partikelteilstrahlen 118 außer dem Kondensorsystem 31-32 mindestens ein Gruppenablenksystem 35 und wenigstens ein Multistrahldeflektorarray 51 und 52 des Multideflektorsystems 5.

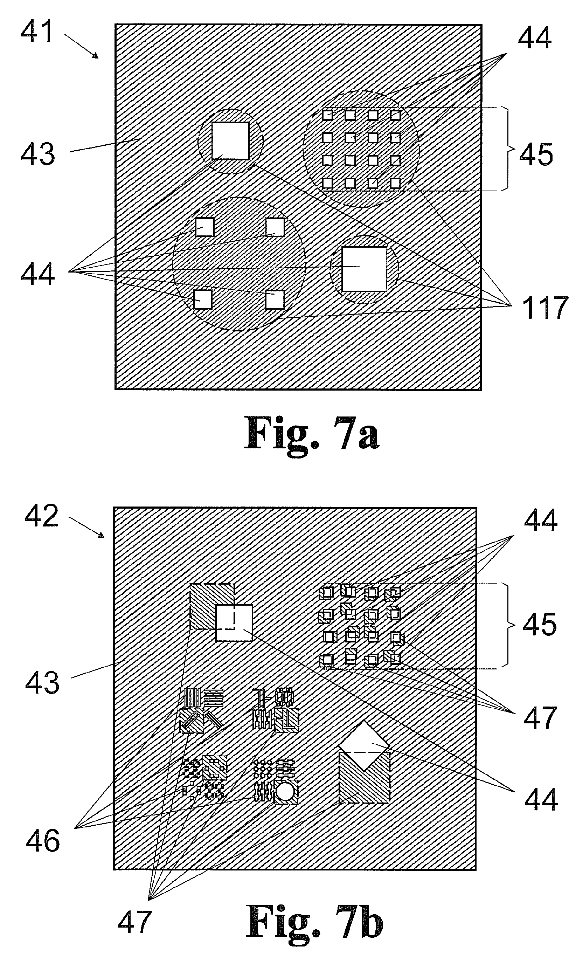

Wird nun das erste Multiformatblendenarray 41 durch eine im Beleuchtungssystem 2 eingestellte Beleuchtungsgruppe 117 im Gebiet einer Strahlformblendengruppe 45 (siehe Fig. 7a) beleuchtet, so wird ein Array von Partikelteilstrahlen 118 erzeugt, das auf seinem Weg hin zum zweiten Multiformatblendenarray 42 das Kondensorsystem 31-32 sowie das kollektive Gruppenablenksystem 35 durchläuft. Durch individuell steuerbare elektrische Felder in jeweils zwei Koordinatenrichtungen innerhalb jedes der Multistrahldeflektorarrays 51 und 52 kann pro Partikelteilstrahl 118 jeweils eine individuelle Verschiebung (Ablenkung) lateral zur Strahlrichtung durch Ablenkung erfolgen.

Die Multistrahldeflektorarrays 51 und 52 sind zweckmäßig in der Nähe zu einem der Multiformatblendenarrays 41 und/oder 42 angeordnet. In einer Entfernung von 10...20% des Abstandes zum nächsten Crossover 112 folgt das dritte Multistrahldeflektorarray 53 als Feinpositioniersystem für die individuelle Positionierung der einzelnen Partikelteilstrahlen 118 auf dem Substrat 91. Dabei ist es notwendig, dass sich wenigstens ein Multistrahldeflektorarray 51 zwischen den beiden Multiformatblendenarrays 41 und 42 befindet, wobei es frei wählbar ist, ob dieses Multistrahldeflektorarray 51 in der Nähe des ersten oder des zweiten Multiformatblendenarrays 41 und 42 angeordnet ist.

Die in Fig. 1 gezeigte Positionierung je eines Multistrahldeflektorarrays 51 bzw. 52 jeweils in der Nähe der Multiformatblendenarrays 41 und 42 kann demzufolge auch noch so abgewandelt werden, dass beide Multistrahldeflektorarrays 51 und 52 in der Nähe des zweiten Multiformatblendenarrays 42 angeordnet sind, und zwar eines davor und das andere danach.

In jedem Fall erfolgt dadurch am Ort des zweiten Multiformatblendenarrays 42 eine Beschneidung jedes Partikelteilstrahles 118 in Abhängigkeit von seiner aktuellen individuellen Verschiebung durch das mindestens eine zwischen den Multiformatblendenarrays 41 und 42 befindliche Multistrahldeflektorarray 51.

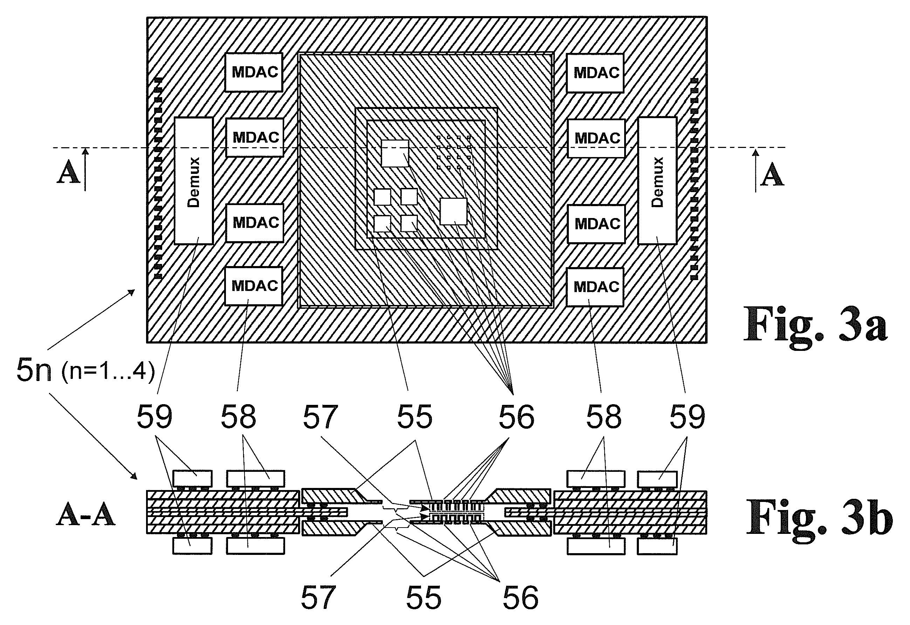

Die Verwendung der speziell strukturierten Multistrahldeflektorarrays 51 und 52, deren konkrete Ausführungen in Fig. 3b, 4a, 4b und 5 dargestellt ist, ermöglicht eine zusätzliche individuelle Positionssteuerung jedes Partikelteilstrahls 118 im Crossover 111 innerhalb des Arrays der Partikelteilstrahlen 118, und zwar unabhängig von deren individueller Formatgröße (Strahlquerschnitt). Dafür ist das mindestens eine dem zweiten Multiformatblendenarray 42 nachgeordnete Multistrahldeflektorarray 51 verantwortlich. Hierbei erfolgt durch ein nachgeordnetes weiteres, gleichartig aufgebautes Multistrahldeflektorarray 53 eine Feinkorrektur der Strahlpositionen im Crossover 112.

Das mehrstufige Gruppenablenksystem 35 im Bereich des Kondensorsystems 31-32 dient der Steuerung von Partikelteilstrahlen 118, die bei Wahl einer Beleuchtungsgruppe 117 im Bereich größerer Blendenöffnungen 44 (30...200 μm Kantenmaß) des Multiformatblendenarrays 41 (siehe Fig. 7a) entstehen. Durch die Ausstattung der Blendenplatten 43 der Multiformatblendenarrays 41 und 42 mit großformatigen Blendenöffnungen 44 (30...200 μm) zusätzlich zu den kleinformatigen (5...20 μm) Blendenöffnungen 44 sind mit derselben Belichtungsanordnung auch größere Beleuchtungsflächen auf dem Substrat 91 realisierbar, um großflächige Strukturen auf dem Substrat 91 zeitsparend belichten zu können.

Fig. 1 zeigt eine erste Ausführungsform der Erfindung, bei der die Beleuchtung - der Einfachheit wegen - durch eine einzelne Partikelstrahlquelle 1 erfolgt, die durch einen Anpasskondensor 21, ein Beleuchtungsgruppenselektor 22, der ein Strahlablenksystem zur Auslenkung des Partikelstrahls 11 aus der optischen Achse 115 darstellt, sowie einen Stigmator 23 komplettiert ist. Funktionell bildet der Kondensor 21 des Beleuchtungssystems 2 die Strahlaustrittsblende 116 der Partikelstrahlquelle 1 auf ein erstes Multiformatblendenarray 41 ab und erzeugt ein erstes Zwischenbild des Strahlaustritts 10 der Partikelstrahlquelle 1 im Crossover 110.

Abhängig von einem auf dem Substrat 91 zu erzeugenden Strukturmuster erfolgt im Beleuchtungssystem 2 der Partikelstrahlsäule, die durch eine lineare optische Achse 115 vom Strahlaustritt der Partikelstrahlquelle 1 bis zum Zielpunkt auf dem zu belichtenden Substrat 91 gekennzeichnet ist, eine automatische Auswahl und Steuerung einer Beleuchtungsgruppe 117 zur selektiven Ausleuchtung einer definiert geformten Blendenöffnung 44 oder einer Strahlformungsblendengruppe 45 des ersten Multiformatblendenarrays 41. Diese Auswahl der Strahlformungsblenden erfolgt durch geeignete Ablenkung des Partikelstrahls 11 mittels des Beleuchtungsgruppenselektors 22.

Es können - bei Verwendung eines ersten Multiformatblendenarrays 41 gemäß Fig. 7a - einzelne große variable Partikelformstrahlen durch große Blendenöffnungen 44 sowie ein Array kleiner variabler Partikelteilstrahlen 118 durch die Strahlformungsblendengruppe 45 ausgewählt werden. Weiterhin können - bei Verwendung eines zweiten Multiformatblendenarrays 42 gemäß Fig. 7b, bei dem die Blendenplatte 43 nicht die gleichen Blendenöffnungen 44 wie das erste Multiformatblendenarray 41 aufweist - auch andere Strahlformungsvarianten, wie z.B. Rhomben, Dreiecke etc. (Erzeugungsprinzip entsprechend DD 241 500 A1) oder aber spezielle Charaktere 46 (Fig. 7b) erzeugt werden, wie unten zu Fig. 7b noch genauer beschrieben wird.

Weitere Varianten der Strahlformung eines einzelnen Partikelstrahlquerschnitts relativ großer variabler Fläche durch die Abbildung zweier Blenden aufeinander mit einem Strahlablenksystem dazwischen erfolgen in der im Stand der Technik bereits bekannten Art und Weise (z.B. US 6,175,122 B1, US 6,614,035 B2). Auch die Erzeugung und Projektion von speziellen Charakteren 46 (s. Fig. 7b) bzw. die Abbildung von Teilen davon, die durch eine der größeren Öffnungen 44 im ersten Multiformatblendenarray 41 und einen Charakter 46 im zweiten Multiformatblendenarray 42 bereitgestellt (ausgewählt) werden, sind bekannt.

Der Stigmator 23 ist zur Korrektur eines eventuell auftretenden Astigmatismus im Crossover 111 des Beleuchtungssystems 2 vorgesehen.

Die wesentliche Neuerung der Erfindung besteht in der zusätzliche Möglichkeit der Strahlquerschnittssteuerung eines Arrays (Gruppe) von Partikelteilstrahlen 118 mittels Multistrahldeflektorarrays 51, 52 in der Nähe wenigstens eines der Multiformatblendenarrays 41 und 42, wodurch variabel geformte Partikelteilstrahlen 118 kleiner Strahlquerschnittsfläche (5...20 μm) individuell steuerbar gleichzeitig oder aufeinanderfolgend innerhalb derselben Partikelstrahlsäule ohne mechanische Blendenwechsel erzeugt werden können.

Die völlig unabhängige Steuerung der Größe des individuellen Strahlquerschnitts in zwei Koordinatenrichtungen lateral zur Strahlrichtung und die zusätzliche individuelle Positionsablenkung jedes Partikelteilstrahls 118 auf dem Substrat 91 ermöglichen eine wesentlich schnellere simultane Belichtung von mehreren unterschiedlichen Strukturen eines auf dem Substrat 91 zu belichtenden Chipdesigns.

Da ein zu belichtendes Chipdesign auf dem Substrat 91 jedoch meist auch einige große Strukturen bzw. häufig wiederholte Charaktere 46 enthält, ist es häufig von Vorteil, zur Belichtung solcher Strukturbereiche die jeweils produktivste Strahlformungsblendengruppe 45 (siehe Fig. 7a, 7b) auswählen zu können, ohne ein oder beide Multiformatblendenarrays 41 bzw. 42 austauschen zu müssen. Diese Blendenauswahl geschieht zunächst innerhalb des Beleuchtungssystems 2 mittels des Beleuchtungsgruppenselektors 22.

Wird das erste Multiformatblendenarray 41 durch eine im Beleuchtungssystem 2 eingestellte Beleuchtungsgruppe 117 im Gebiet einer Strahlformblendengruppe 45 (siehe Fig. 7a) beleuchtet, so wird ein Array von Partikelstrahlen 118 erzeugt, das auf seinem Weg durch das Kondensorsystem 31-32 zum zweiten Multiformatblendenarray 42 neben den zwei Kondensorlinsen 31 und 32 mindestens ein Multistrahldeflektorarray 51, drei kollektive Gruppenablenksysteme 351, 352 und 353 sowie eine Korrekturlinse 33 durchläuft.

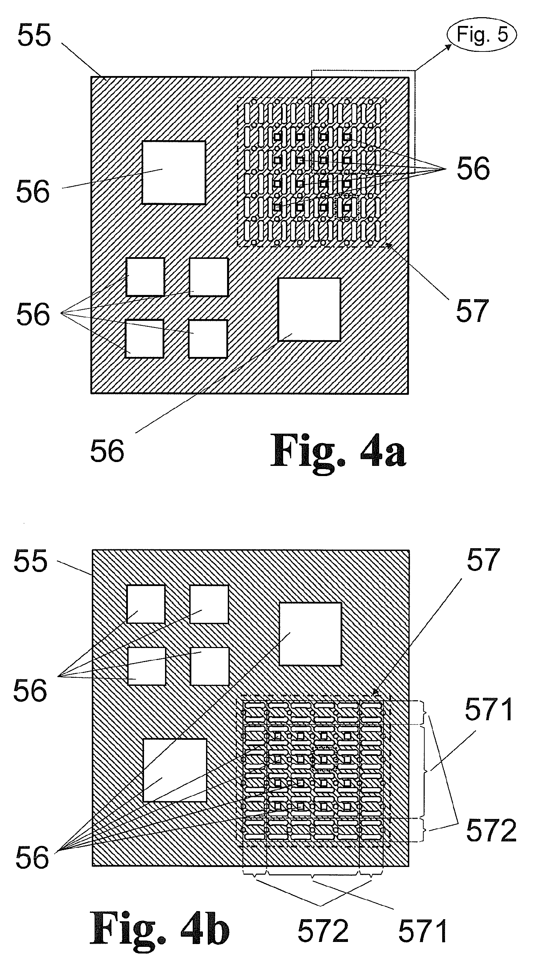

Das mindestens eine Multistrahldeflektorarray 51, 52 ermöglicht eine individuelle Verschiebung jedes einzelnen durch das erste Multiformatblendenarray 41 erzeugten Partikelteilstrahls 118 in jeweils zwei Koordinatenrichtungen, wie weiter unten zu den Fig. 3a und 3b und Fig. 4a und 4b noch ausführlicher erläutert wird.

Am Ort des zweiten Multiformatblendenarrays 42 erfolgt eine Beschneidung jedes Partikelteilstrahles 118 in Abhängigkeit seiner individuellen lateralen Verschiebung, wie es in Fig. 7b durch Einzeichnung der (enger schraffierten) Teilstrahlquerschnitte 47 erkennbar ist, indem die einzelnen Partikelteilstrahlen 118 auf die Durchschnittsfläche von Teilstrahlquerschnitt und jeweiliger Blendenöffnung des Multiformatblendenarrays 42 verringert werden.

Die Verwendung von speziell strukturierten Multistrahldeflektorarrays 51, 52 und gegebenenfalls weiterer Multistrahldeflektorarrays 53 oder 54, deren konkrete Ausführungen in Fig. 3b, 4a, 4b und 5 dargestellt sind, ermöglicht eine zusätzliche individuelle Positionssteuerung der Crossover 111 und 112 für jeden Partikelteilstrahl 118 innerhalb des Arrays der (kleinformatigen) Partikelteilstrahlen 118 unabhängig von deren individueller Formatgröße. Dadurch kann nach der Aufteilung des Partikelstahls 11 in Partikelteilstrahlen 118 ein üblicherweise eng begrenzter Crossover 111, 112 oder 113 in räumlich nicht mehr zusammentreffende Teil-Crossover verteilt werden. Trotz dieser vorteilhaft angestrebten räumlichen Verteilung individueller Teil-Crossover wird nachfolgend weiterhin der Begriff Crossover 111, 112 oder 113 benutzt, um die Lage der die individuellen Crossover einer Orthogonalebene zur optischen Achse 115 zuzuordnen.

Ein mehrstufiges Gruppenablenksystem 35 im Bereich des Doppelkondensorsystems 31-32 dienen der Steuerung der Partikelteilstrahlen 118 bei Wahl einer Beleuchtungsgruppe 117 im Bereich größerer Blendenöffnungen 44 (30...200 μm) des Multiformatblendenarrays 41.

Wird ein dreistufiges Gruppenablenksystem 35 verwendet, wie es in Fig. 1, 2, 8 und 9 genauer mit Gruppenablenksystemen 351 bis 353 bezeichnet ist, so ermöglicht vorzugsweise das mittlere Ablenksystem 352 eine Strahlquerschnittssteuerung (Formatgrößensteuerung) oder die Auswahlsteuerung von speziellen Blendenstrukturen 46 (Fig. 7b) im zweiten Multiformatblendenarray 42 und die Ablenksysteme 351 und 353 sind zur Austastung von einzelnen Partikelteilstrahlen 118 vorgesehen, so dass diese Partikelteilstrahlen 118 entweder bereits am zweiten Multiformatblendenarray 42 oder im weiteren Strahlverlauf auf die im Crossover 113 positionierte Aperturblende 7 treffen.

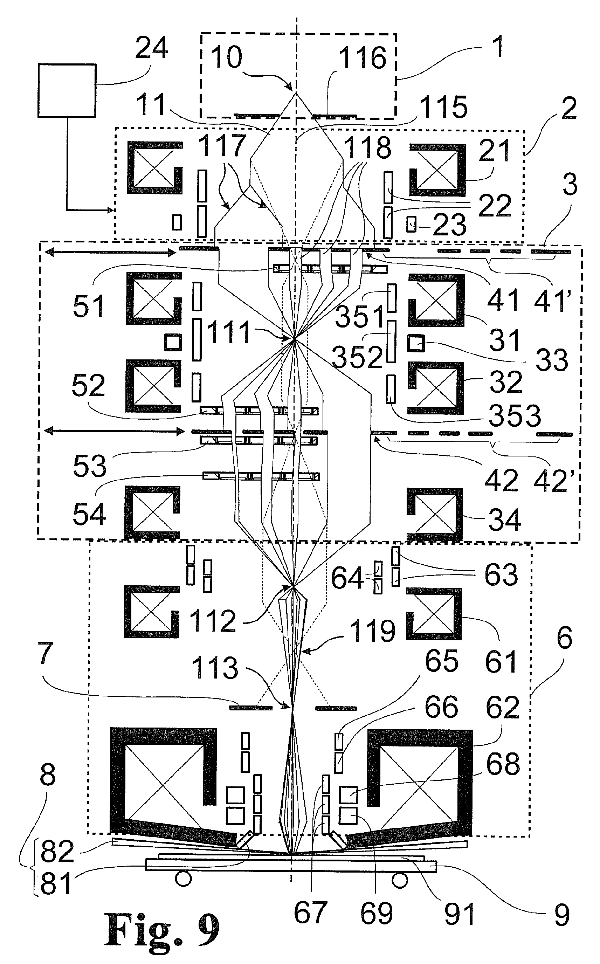

Da die Multiformatblendenarrays 41 und 41 dem ständigen Beschuss mit dem Partikelstrahl 11 bzw. den Partikelteilstrahlen 118 ausgesetzt sind, kann es vorteilhaft sein, dass mehrere Multiformatblendenarrays 41, 42 so anordnet sind, dass sie bei Bedarf (z.B. bei Verschleiß oder anderen Designerfordernissen) als gekoppelte, d.h. auf einem Chip geätzte, Multiformatblendenarrays (41', 41", ... bzw. 42', 42", ...) lateral zur optischen Achse 115 verschiebbar und dadurch austauschbar sind, ohne die Partikelstrahlsäule neu justieren zu müssen. Eine solche Variante ist beispielhaft in Fig. 9 durch austauschbare gleichartige Multiformatblendenarrays 41' und 42' dargestellt.

Zusätzlich kann im Strahlmodulatorsystem 3 eine Korrekturlinse 33 zwischen den Kondensorlinsen 31 und 32 vorhanden sein, die eine hochgenaue Winkelausrichtung des Bildes des ersten Multiformatblendenarrays 41 am Ort des zweiten Multiformatblendenarrays 42 ermöglicht, um mechanische Justierungstoleranzen auszugleichen.

Dem bisher beschriebenen Teil der Beleuchtungs- und Multiformstrahlsteuerung folgt - im weiteren Strahlweg der Partikelstrahlsäule in Richtung auf den Substrattisch 9 ein Verkleinerungssystem 6, das mittels elektromagnetischer Linsen 61 und 62 eine verkleinerte Abbildung des zweiten Multiformatblendenarrays 42 auf das auf dem Substrattisch 9 befindliche Substrat 91 vornimmt. Dabei sind außer der dargestellten zweistufigen Verkleinerungsoptik 61-62 aber auch Optiken mit nur einer oder mit drei Linsen einsetzbar

Das Verkleinerungssystem 6 ist mit mannigfaltigen Ablenksystemen zur Steuerung der Partikelstrahlpositionen auf dem Substrat 91 ausgestattet, wie Strahlrückführsystem 63, Strahlnachführung 65, Mikrostrahlablenkung 66 und Makrostrahlablenkung 67 sowie Stigmatoren 64 und 69 und eine schnelle Fokussierlinse 68. Für die verkleinerte Abbildung des zweiten Multiformatblendenarrays 42 auf das Substrat 91 beträgt der Abbildungsmaßstab typischerweise 30:1 ... 100:1.

Nach etwa 10...20 % des Abstandes zwischen dem zweiten Multiformatblendenarray 42 und dem nächsten Crossover 112 befindet sich ein drittes Multistrahldeflektorarray 53 (als Feinpositioniersystem für die Position jedes Partikelteilstrahles 118 auf dem Substrat 91). Dieses Feinpositioniersystem 53 gleicht den Multistrahldeflektorarrays 51 und 52 prinzipiell, besitzt jedoch einen anderen Skalierungsfaktor. Es gestattet eine kleine individuelle Positionsverschiebung jedes Partikelteilstrahls 118 (5...20 μm) lateral zur Strahlrichtung.

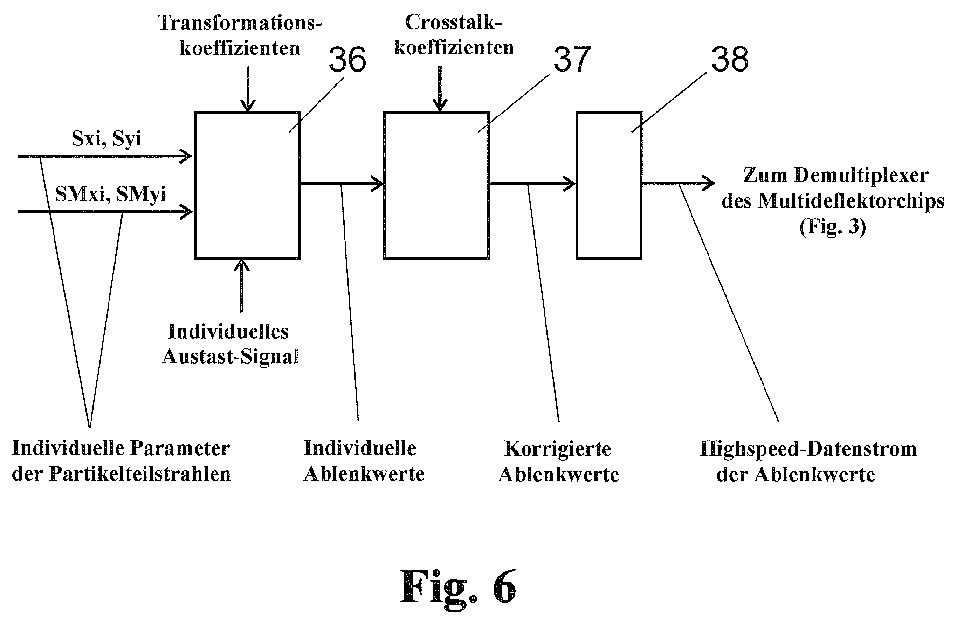

Die elektronische Ansteuerung der jeweils zwei Deflektorzellenarrays 57 innerhalb jedes der Multistrahldeflektorarrays 51, 52 und 53 erfolgt über eine einzige kalibrierte Koppelmatrix, die gemäß Fig. 6 erzeugt und geeignet weiter verarbeitet wird, um allen Partikelteilstrahlen 118 im Array eine individuelle Formatgröße $(S_{xi}, S_{yi})$, eine individuelle Feinpositionierung $(SM_{xi}, SM_{yi})$ und eine individuelle Position des Crossovers 112 aufprägen zu können. Dazu werden die aus dem zu belichtenden Chipdesign abgeleiteten aktuellen Parameter, Formatgröße $(S_{xi}, S_{yi})$ und $(SM_{xi}, SM_{yi})$ und Feinpositionierung in einem digitalen Koppelmatrix-Rechenwerk 37 mit geeigneten Transformationskoeffizienten und Austastsignalen für einzelne der Partikelteilstrahlen 118 in individuelle Ablenkwerte für jeden Deflektor (Elektrodenpaar 573) der insgesamt sechs Deflektorzellenarrays 57 umgewandelt. Aufgrund der eng benachbarten Struktur der Deflektorzellenarrays 57 werden die individuellen Ablenkwerte aus dem Koppelmatrix-Rechenwerk 37 anschließend in einem Crosstalk-Korrektur-Rechenwerk 38 mit Crosstalk-Koeffizienten, die die spezielle Struktur der Deflektorzellenarrays 57 berücksichtigen, in korrigierte Ablenkwerte umgerechnet und einem Datenmultiplexer 39 zugeführt. Der Datenmultiplexer 39 erzeugt einen Highspeed-Datenstrom der Ablenkwerte zu den einzelnen Demultiplexern 59 der sechs einzelnen Deflektorchips 55 (siehe Fig. 3). Die gesamte Prozedur der Berechnung der individuellen korrigierten Ablenkwerte erfolgt innerhalb der Rechenwerke 37 und 38 in Echtzeit für alle Multideflektorarrays 51, 52 und 53 (Pipelinestruktur).

Im Strahlweg vor der ersten Verkleinerungsstufe (Linse 61) sind ein zweistufiges Strahlrückführsystem 63 und ein zweistufiger Stigmator 64 angeordnet. Das Strahlrückführsystem 63 sorgt dafür, dass die Partikelteilstrahlen 118 von der jeweils verwendete Strahlformblendengruppe 45, die sich zweckmäßig außerhalb der optischen Achse 115 befinden sollte, wieder auf die optische Achse 115 gelenkt wird, ohne die Position des Crossovers 112 entlang der optischen Achse 115 zu beeinflussen. Dies dient der Reduzierung von Aberrationen. Ebenso kann der Stigmator 64 helfen, die Verzeichnung zu reduzieren.

Die zweite Verkleinerungsstufe (Linse 62) bildet das verkleinerte Zwischenbild 119 der durch die Blendenöffnungen 44 durchgelassenen Anteile der Teilstrahlquerschnitte 47, die vom Beleuchtungsbereich 117 durch das erste Multiformatblendenarray 41 (Fig. 7a) vorgegeben und über die Gruppenablenksysteme 35 und die individuellen Ablenksysteme der Multistrahldeflektorarrays 51 und 52 sowie die Form- und Größenänderung durch die zweite Multiformatblendenarray 42 individuell verändert wurde, nochmals verkleinert auf das Substrat 91 ab.

Die Aperturblende 7 definiert hierbei die Substratapertur und dient als Austastblende für temporär nicht verwendete Partikelteilstrahlen 118. Die Strahlposition des verkleinerten Bildes der verwendeten Strahlformblendengruppe 45 kann mittels Mikrostrahlablenkung 66 und Makrostrahlablenkung 67 in der üblichen Weise auf dem Substrat 91 positioniert werden.

Weiterhin kann - entsprechend der Gestaltung gemäß Fig. 1 - ein Ablenksystem 65 zur Strahlnachführung während der Belichtung des Substrats 91 auf dem kontinuierlich bewegten Substrattisch 9 von Vorteil sein. Eine schnelle Fokussierlinse 68 dient im Zusammenwirken mit einem weiteren Stigmator 69 auf Basis der Messwerte eines Höhensensors 81 der kontinuierlichen, exakten Fokussierung der Partikelteilstrahlen 118 auf dem Substrat 91. Typische Unebenheiten des Substrats 91 sowie eine mögliche Ablenkdefokussierung können hiermit korrigiert werden. Der Rückstreu-Partikeldetektor 82 dient der Markenerkennung und Strahlkalibrierung.

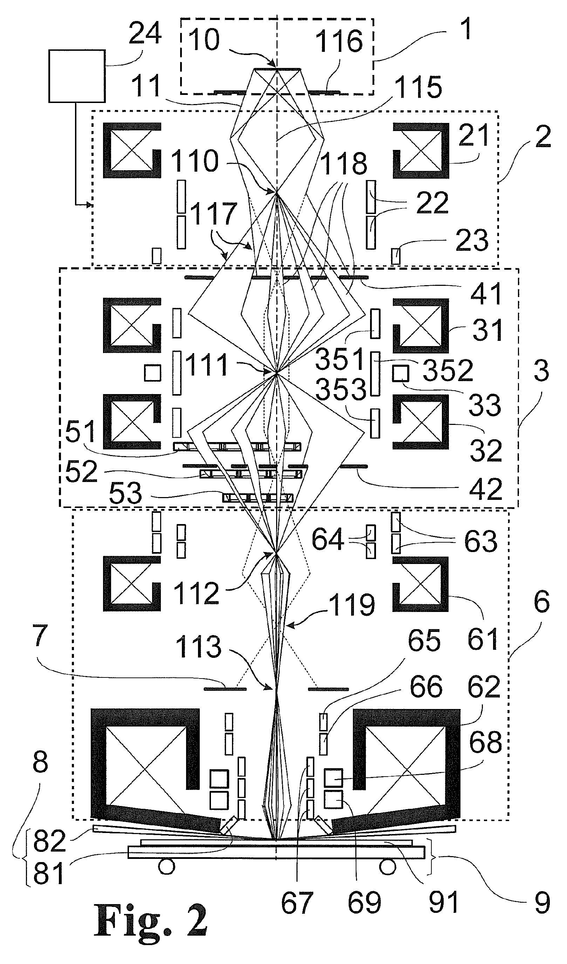

Fig. 2 zeigt - bei ansonsten gleichem Aufbau der Partikelstrahlsäule gemäß Fig. 1 - eine andere Konfiguration des Multistrahldeflektorsystems 5.

In diesem Beispiel sind alle Multistrahldeflektorarrays 51 in der Nähe des Multiformatblendenarrays 42 positioniert. Dabei sorgt das vor dem zweiten Multiformatblendenarray 42 angeordnete Multistrahldeflektorarrays 51 für die Strahlablenkung der Partikelteilstrahlen 118, um eine individuell unterschiedliche Größenbeschneidung ihrer Querschnitte durch das Multiformatblendenarray 42 zu erreichen. Das Multistrahldeflektorarray 52 bewirkt die Rückstellung der Neigungen der einzelnen Partikelteilstrahlen 118 um entgegengesetzte Beträge, um die sie mit Hilfe des ersten Multistrahldeflektorarrays 51 (zum Zwecke der Formatbeschneidung durch das zweite Multiformatblendenarray 42) ausgelenkt wurden. Mit dem dritten Multistrahldeflektorarray 53 in Form eines Feinpositionierarrays erfolgt die Feinauslenkung der einzelnen Partikelteilstrahlen 118 für deren Position auf dem Substrat 91.

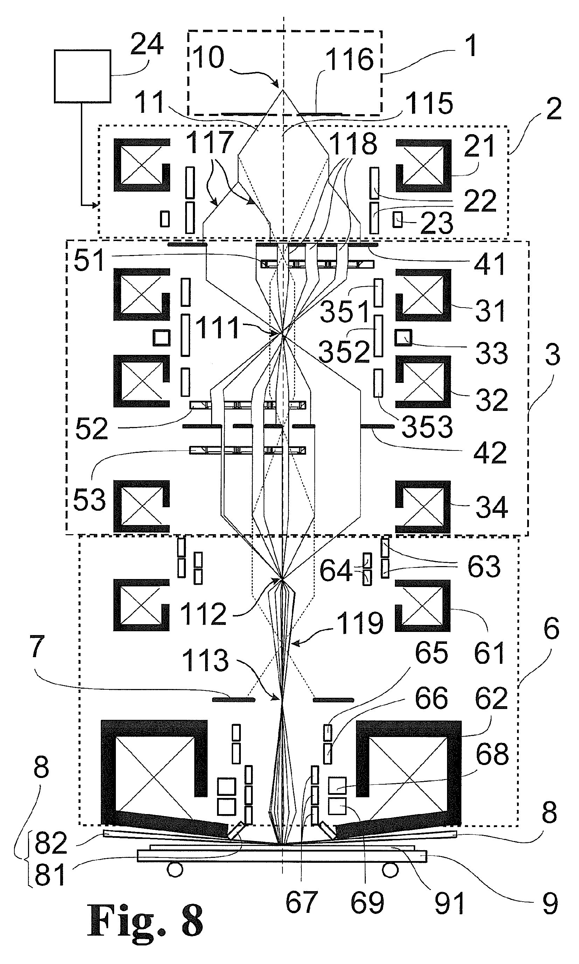

Fig. 8 zeigt den Pupillenstrahlengang einer anderen Variante eines partikeloptischen Abbildungssystems für ein Multiformstrahl-Lithographiesystem. Wie in der Variante gemäß Fig. 1 oder 2 ist die Beleuchtung der Partikelstrahlquelle 1 durch den Strahlaustritt 110 und die Austrittsaperturblende 116 festgelegt.

In dieser Ausführungsvariante sorgt die Kondensorlinse 21 des Beleuchtungssystems 2 jedoch für eine telezentrische Beleuchtung des ersten Multiformatblendenarrays 41. Der Beleuchtungsgruppenselektor 22 dient der Strahljustierung sowie der gezielten Selektion (d.h. örtlich begrenzten Beleuchtung) einer bestimmten Strahlformungsblendengruppe 45 auf dem Multiformatblendenarray 41 (Fig. 7a). Der Stigmator 23 ist zur Korrektur eventuell auftretenden Astigmatismus im Crossover 111 vorgesehen.

Das Kondensorlinsensystem 31-32 sorgt wie in Variante 1 für eine 1:1-Abbildung des ersten Multiformatblendenarrays 41 auf das zweite Multiformatblendenarray 42. Die Multistrahldeflektorarrays 51 und 52 ermöglichen die individuelle Verschiebung jedes der durch das zweite Multiformatblendenarray 41 erzeugten Partikelteilstrahlen 118 innerhalb des Arrays in zwei Koordinatenrichtungen. Am Ort des zweiten Multiformatblendenarrays 42 erfolgt eine Beschneidung jedes Partikelteilstrahls 118 nach Maßgabe seiner individuellen Verschiebung. Drei weitere Ablenksysteme 351, 352, 353 im Bereich des Kondensorlinsensystems 31-32 dienen wie bei Variante 1 der Steuerung von Strahlformblendengruppen 45 mit großem Strahlquerschnitt. Ebenso dient Linse 33 wieder der hochgenauen Winkelausrichtung des Bildes des ersten Multiformatblendenarrays 41 am Ort des zweiten Multiformatblendenarray 42.

Im Unterschied zur ersten Ausgestaltungsvariante gemäß Fig. 1 wird in Fig. 8 eine dreistufige Verkleinerungsoptik eingesetzt (60, 61 und 62). Die Linse 60 erzeugt ein Zwischenbild des Crossovers 111 und sorgt für einen weiterhin telezentrischen Strahlverlauf bzgl. des zweiten Multiformatblendenarrays 42. Das Verkleinerungssystem 6 besteht im Weiteren, wie zu den Varianten gemäß den Fig. 1 und 2 beschrieben, aus den Linsen 61 und 62 und sorgt für die entsprechende verkleinerte Abbildung (30...100:1) des zweiten Multiformatblendenarrays 42 auf das Substrat 91. Beide Varianten gemäß Fig. 1 und Fig. 8 verwenden die gleichen übrigen Positionier- sowie Mess- und Korrektursysteme.

Der wesentliche Vorteil der Variante gemäß Fig. 8 gegenüber den Ausführungen von Fig. 1 und 2 besteht darin, dass das dritte Multistrahldeflektorarray 53 zur individuellen Feinpositionierung der Teilstrahlen 118 auf dem Substrat 91 baugleich sein kann mit den beiden Multistrahldeflektorarrays 51 und 52. Dadurch werden Justiervorgänge vereinfacht.

Ein prinzipieller Vorteil der in Fig. 8 dargestellten Abbildungsvariante besteht in der Vermeidung eines Zwischenbildes des Strahlaustritts 10 der Partikelquelle 1 vor dem ersten Multiformatblendenarray 41, wie es als Crossover 110 in der ersten Variante (gemäß Fig. 1) entsteht.

Da im Beleuchtungssystem 2 der Gesamtstrom der Partikel stets höher als in den nachfolgenden Abbildungsstufen ist, kommt es hier im Kreuzungspunkt (Crossover 110) der Partikelteilstrahlen 118 zu erheblichen Wechselwirkungen. Solche Wechselwirkungen können zu einer störenden Energieverbreiterung im Strahl beitragen, die zusätzliche chromatische Fehler in den nachfolgenden Linsen verursacht und dadurch letztlich die Auflösung verschlechtert. Deshalb ist die vorstehend zu Fig. 8 beschriebene Anordnung der Partikelsäule in dieser Hinsicht vorteilhafter als die Varianten gemäß den Fig. 1 und 2.

In Fig. 9 ist eine modifizierte Variante der Partikelstrahlsäule mit telezentrischer Beleuchtungsform gemäß Fig. 8 dargestellt. Dabei sind im Strahlmodulatorsystem 3 anstelle der ursprünglich vorgesehenen drei Multistrahldeflektorarrays 51 bis 53 vier solche Multistrahldeflektorarrays 51-54 vorhanden. Während das erste Multistrahldeflektorarray 51 die individuelle Positionssteuerung der Partikelteilstrahlen 118 im Crossover 111 organisiert, um hier möglichst geringe Wechselwirkungen zwischen den einzelnen Partikelteilstrahlen 118 zu erzeugen, ist das zweite Multistrahldeflektorarray 52 für die gesonderte Ausrichtung der einzelnen Partikelteilstrahlen 118 für deren Formatbeschneidung durch das zweite Multiformatblendenarray 42 vorgesehen. Das dritte Multistrahldeflektorarray 53 bewirkt die Rückstellung der im Zuge der Formatbeschneidung individuellen Richtungsänderungen der Partikelteilstrahlen 118 und das vierte Multistrahldeflektorarray 54 sorgt als Feinpositionierarray wiederum für die individuelle Positionierung der Partikelteilstrahlen 118 auf dem Substrat 91.

Im Folgenden soll nochmals genauer auf den Aufbau und die Wirkungsweise der Multistrahldeflektorarrays 51 und 52 sowie der Feinpositionierarrays 53 und 54 eingegangen werden, wobei letztere im Wesentlichen bau- und funktionsgleich zu den Multistrahldeflektorarrays 51 und 52, jedoch durch Skalierung verkleinert ausgebildet sind.

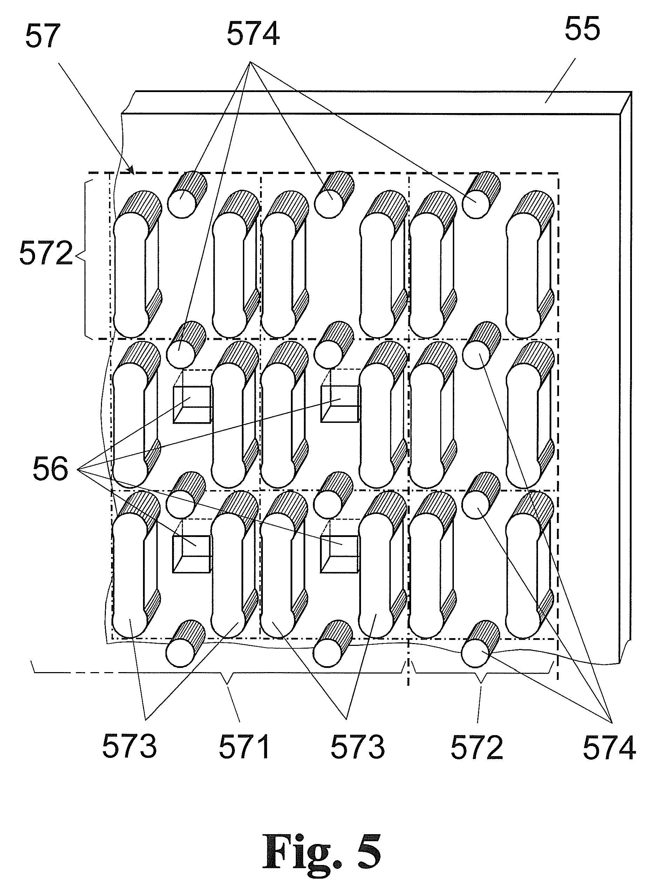

Die Multistrahldeflektorarrays 51 bis 54 weisen jeweils zwei in Strahlrichtung der Partikelteilstrahlen 118 eng (< 1 mm) benachbarte, lateral im wesentlichen orthogonal zueinander ausgerichtete Deflektorzellenarrays 57 auf, die im Wesentlichen aus einer regelmäßigen Anordnung von Elektrodenpaaren 573 und Abschirmelektroden 574 bestehen. Eine Ausführung als 90°-Anordnung der Elektrodenpaare 573 ist in Fig. 4 und einem daraus vergrößerten Ausschnitt in Fig. 5 dargestellt, wobei man sich den Deflektorchip 55 von Fig. 4a als entlang der Blattmitte über den in Fig. 4b gezeigten Deflektorchip 55 übergeklappt vorstellen muss, so dass die Flächen der Deflektorchips 55, auf denen die Elektroden 573 und 574 angeordnet sind, zueinander zeigen.

Die Ansteuerung der Multistrahldeflektorarrays 51, 52, 53, deren Hardware-Realisierung in Fig. 3a gezeigt ist, erfolgt über elektronische Rechenwerke in einer Pipelinestruktur, wie sie in Fig. 6 gezeigt ist. Die bereits oben erwähnte Koppelmatrix gewährleistet, dass alle Partikelteilstrahlen 118 im Teilstrahlenarray eine individuelle Querschnittsgröße ($S_{xi}$, $S_{yi}$), eine individuelle Feinpositionierung ($SM_{xi}$, $SM_{yi}$) und eine individuelle Position im Crossover 112 aufweisen können. Für die individuelle Position der Partikelteilstrahlen 118 im Crossover 112 sind im Wesentlichen zwei Positionseinstellungen von Interesse:

    a) exakt auf der optischen Achse 115 - für die Belichtung - oder
    b) möglichst weit entfernt von der optischen Achse 115 - für die Austastung des Partikelteilstrahls 118 an der Austrittsaperturblende 7.

Um aus den Werten für die individuelle Formatgröße ($S_{xi}$, $S_{yi}$) und die individuelle Feinpositionierung ($SM_{xi}$, $SM_{yi}$) jedes Partikelteilstrahls 118 über eine individuelle Koppelmatrix die Ablenkwerte für die individuellen Deflektorzellen 571 mehrerer Multistrahldeflektorarrays 51, 52, 53 (und ggf. 54) zu bestimmen und anschließend eine Kompensation des durch in der Ebene benachbarten Deflektorzellen 571 bedingten Crosstalks durchzuführen, sind ein oder mehrere digitale Rechenwerke zur Realisierung von aus Multiplikationen und Additionen bestehenden linearen Transformationen notwendig. Durch im Design der Deflektorzellenarrays 57 vorgesehene, Dummy-Deflektorzellen 572 entfällt die Notwendigkeit einer Sonderbehandlung der am Rand und in den Ecken des Partikelteilstrahlarrays liegenden Partikelteilstrahlen 118, so dass alle Ablenkwerte nach dem gleichen Algorithmus berechnet werden können, der jedoch auf individuelle Transformations- bzw. Koppelkoeffizienten zurückgreift. Die Eigenschaft des Designs der Deflektorzellenarrays 57, dass um die aktiven Deflektorzellen 571, die jeweils einen Partikelteilstrahl 118 ablenken, eine äußere Reihe von passiven Deflektorzellen (Dummy-Deflektorzellen 572) angeordnet sind, garantiert einen hohen Grad von Parallelisierbarkeit in der Berechnungs- und Ansteuerelektronik.

Da die Koppelkoeffizienten vom aktuellen Justagezustand des Deflektorzellenarrays 57 der Partikelteilstrahlen 118 abhängen, können die Transformationen nicht als Teil einer Off-line-Datenverarbeitung abgearbeitet werden, sondern müssen in Echtzeit während der Belichtung erfolgen.

Aus Produktivitätsgründen sind rein sequentiell (Ablenkwert für Ablenkwert, Teilstrahl für Teilstrahl) arbeitende Rechenarchitekturen nicht einsetzbar. Zur Erreichung ausreichender Durchsatzraten sind parallel arbeitende Rechenblöcke erforderlich, die z.B. jeweils einem Partikelteilstrahl 118 oder einer Zeile oder Spalte von Partikelteilstrahlen 118 in einem Multistrahldeflektorsystem aus drei oder vier Multistrahldeflektorarrays 51 bis 54 zugeordnet sind. Durch Zerlegung des Rechenalgorithmus in Teiloperationen von Additionen und Multiplikationen, die in parallel arbeitenden Blöcken ausgeführt werden, ist es außerdem möglich, die Berechnungsfunktionen mit denen des Datentransports zu verknüpfen, wodurch Pipeline-Strukturen bzw. systolische Prozessorarrays nutzbar sind. Derartige Rechenarrays können in modernen programmierbaren Logikschaltkreisen (FPGA) höchster Integrationsdichte, die auch die nötige Bandbreite für Input und Output bereitstellen, realisiert werden.

Nach der digitalen Berechnung der individuellen Ablenkwerte für jeden Deflektorchip 55 muss zur Bereitstellung der Ablenkpotentiale für die einzelnen Deflektorzellen 571 eine Digital-Analog-Wandlung erfolgen. Da jede Deflektorzelle 571 aus Elektrodenpaaren 573 besteht und deshalb zwei symmetrisch zu einer Bezugsmasse (Abschirmelektrode 574) liegende Ansteuerspannungen benötigt, sind zur Steuerung von n Partikelteilstrahlen 118 in sechs Deflektorebenen (d.h. in drei Doppeldeflektorarrays mit jeweils den Ablenkrichtungen X und Y) von erstem und zweitem Multistrahldeflektorarray 51 und 52 sowie dem als Feinpositionierungsarray fungierenden dritten Multistrahldeflektorarrays 53 insgesamt 12n Spannungspotentiale zu generieren. Bei der Realisierung dieses Schaltungsteils ist es sinnvoll, mehrkanalige aktive Bauelemente wie Multi-DA-Wandler 58 mit entsprechenden Mehrfach-Operationsverstärkern einzusetzen.

Mit zunehmender Anzahl n der zu steuernden Partikelteilstrahlen 118 stellt die Aufbau- und Verbindungstechnik zur Zuführung der 12n Spannungen von außerhalb der elektronenoptischen Säule befindlichen DAC-Boards in den Vakuumbereich der Partikelstrahlsäule ein wachsendes Problem dar. Ab n > 64 wird deshalb eine Lösung favorisiert, bei der nicht die einzelnen Analogspannungen separat, sondern die digitalen Ansteuerwerte multiplex über einige wenige serielle Highspeed-Verbindungen mit Datenraten > 1 Gigabyte/Sekunde in den Vakuumbereich der Partikelstrahlsäule transferiert werden. Dabei kann die Übertragung mittels differentieller elektrischer Signale oder optisch über Glasfaser oder Freistrahloptik realisiert werden. Das Demultiplexen der Ansteuerdaten und deren D/A-Wandlung kann dann direkt auf jedem Deflektorchip 55 des Multistrahldeflektorsystems 5 erfolgen.

Eine derartige Ansteuerung ist in Fig. 3 schematisch dargestellt. Zwei integrierte Demultiplexer-Chips 59 versorgen rechts und links jeweils vier integrierte Multi-DA-Wandler 85 zur Ansteuerung des nahezu mittig positionierten Deflektorchips 55. Zwei unabhängige, mit gleichen Elektronikbausteinen bestückte Deflektorplatinen, die jeweils einen Deflektorchip 55 halten und mit separaten Ansteuersignalen versorgen, werden für zwei übereinander liegende Deflektorzellenarrays 57 dazu benutzt, um einzeln die X- bzw. die Y-Ablenkung der separaten Partikelteilstrahlen 118 mit zueinander orthogonal orientierten Elektrodenpaaren 574 in den zwei übereinander liegenden Ebenen der Deflektorzellenarrays 57 zu realisieren.

Mit dieser Schaltungsanordnung wird neben dem Problem der Signalzuführung auch die Forderung nach kurzen Einschwingzeiten der Deflektorzellenarrays 57 durch kompakten Aufbau und sehr kurze kapazitätsarme Ansteuerleitungen erfüllt.

Wie in Fig. 4a und 4b sowie Fig. 5 in konkreten Ausführungen der Deflektorchips 55 dargestellt, werden innerhalb des Deflektorzellenarrays 57 Deflektorchipausschnitte 56 eingebracht, die der Strahlformungsblendengruppe 45 für kleinformatige Partikelteilstrahlen 118 (5-20 $\mu$m) des Multiformatblendenarrays 41 zugeordnet sind und gleichartig geformte oder größer dimensionierte Deflektorplattenausschnitte 56 aufweist, um die einzelnen vom Multiformatblendenarrays 41 bereitgestellten Partikelteilstrahlen 118 nicht zu beschneiden, sondern gezielt individuell in ihrer Strahlrichtung zu beeinflussen.

Zu diesem Zweck wird jeder einzelnen Blendenöffnung 44 der Strahlformungsblendengruppe 45 eines Multiformatblendenarrays 41 bzw. 42 eine individuelle Deflektorzelle 571, bestehend aus einem Elektrodenpaar 573 und zwei Abschirmelektroden 574, zugeordnet, wie es die schematische Darstellung von Fig. 5 als vergrößerter Ausschnitt von Fig. 4a zeigt.

Dabei kann jede der Abschirmelektroden 574, die sich zwischen den parallel ausgerichteten Elektrodenpaaren 573 zweier Deflektorzellen 571 befindet, jeweils die Abschirmung beider benachbarter Deflektorzellen 571 gleichzeitig übernehmen. Die Felder der individuellen Deflektorzellen 571 auf den Multistrahldeflektorarrays 51, 52 und dem Feinpositionierarray 53 wirken trotz der Abschirmelektroden 574 nicht nur auf denjenigen Partikelteilstrahl 118, der seine zugehörige individuelle Deflektorzelle 571 durchläuft, sondern auch auf benachbarte Partikelteilstrahlen 118 (sog. Übersprechen, engl. Crosstalk). Dieses Übersprechen wird wie folgt korrigiert.

Bei einer vorteilhaft verwendeten 8x8 Strahlformungsblendengruppe 45 erweist es sich z.B. als günstig, die Deflektorchips 55 mit 10x10 Deflektorzellen 571, 572 auszustatten.

Zur vereinfachten und übersichtlicheren Darstellung des Aufbaus von optimierten Deflektorzellenarrays 57 sind gemäß Fig. 4a und 4b die Multistrahldeflektorarrays 51 und 52 mit einem 6x6-Deflektorzellenarray 57 mit 4x4 aktiven Deflektorzellen 571 innerhalb eines äußeren Rahmens von jeweils einer Dummy-Deflektorzelle 572, zwischen deren Elektrodenpaar 573 sich kein Deflektorplattenausschnitt 56 befindet, angeordnet. Das 4x4-Array von aktiven Deflektorzellen 571 wird also derart ergänzt, dass sich allseitig um das Feld der sechzehn Deflektorplattenausschnitte 56 jeweils eine Dummy-Deflektorzelle 572 befindet.

Für ein reales 10x10 Deflektorzellenarray 57, das dieses Schema in gleicher Weise mit einem 8x8 Array von aktiven Deflektorzellen 571 verwendet, ergeben sich dann folgende Abschätzungen für das Übersprechverhalten des Deflektorzellenarrays 57.

Die Spannungen an den 10x10 Deflektorzellen 571 sind zunächst bei Vernachlässigung des Übersprechens

$$U_{ij}^{0} \qquad i, j = 0 \ldots 9$$

Die äußeren Reihen des Deflektorzellenarrays 57 sind Dummy-Deflektoren 572 ohne Spannungsbeaufschlagung, d.h.

$$U_{0j}^{0} = U_{9j}^{0} = U_{i0}^{0} = U_{i9}^{0} = 0 \quad i, j = 0 \ldots 9$$

Die eigentlichen Deflektorspannungen für die aktiven Deflektorzellen 571 sind:

$$U_{ij}^{0} \quad i, j = 1 \ldots 8$$

Durch die Einführung der Dummy-Deflektoren 572 "sieht" jede aktive Deflektorzelle 571 dieselbe Umgebung. Das "aktive Deflektorzellenarray" 57 besteht deshalb nur aus den inneren 8x8 aktiven Deflektorzellen 571, deren Spannungen wegen des Übersprechens zu korrigieren sind. Die korrigierten Spannungen seien:

$$U_{ij} \quad i, j = 0 \ldots 9$$

Da der äußere Rahmen um die aktiven Deflektorzellen 571 Dummy-Deflektoren 572 sind, ist

$$U_{0j} = U_{9j} = U_{i0} = U_{i9} = 0 \qquad i, j = 0 \ldots 9$$

Durch das Übersprechen wird die Ablenkwirkung einer individuellen Deflektorzelle 571 durch die Störwirkung der anderen Deflektorzellen 571 des Deflektorzellenarrays 57 verändert. Da die Übersprechwirkung klein ist, kann es als ausreichend angesehen werden, die Störwirkung der acht direkten Nachbarn einer betrachteten Deflektorzelle 571 zu berücksichtigen. Die einfachste Möglichkeit zur Korrektur des Übersprechens liegt darin, auf die betrachtete Deflektorzelle 571 eine Korrekturspannung zu geben, die die Übersprechwirkung der Spannungen der acht unmittelbar benachbarten Deflektorzellen 571 kompensieren.

Dazu werden folgende Annahmen gemacht:

1. Die Übersprechwirkung auf weiter entfernte Deflektorzellen 571 (außer den acht direkten Nachbarn) wird vernachlässigt.
2. Es wird vernachlässigt, dass die Korrekturspannungen an der betreffenden Deflektorzelle 571 selbst wieder einem Übersprechen unterliegen (Effekt zweiter Ordnung).
3. Eine innen liegende Deflektorzelle 571 wird ausschließlich durch das Übersprechen aus dessen acht unmittelbar benachbarten Deflektorzellen 571 beeinflusst.

Mit den oben gemachten Annahmen kann jede Deflektorzelle 571 innerhalb eines Neunerfeldes von benachbarten Deflektorzellen 571 und 572 als hinreichend definiert angesehen werden.
Die acht Nachbarzellen einer ausgewählten innen liegenden Deflektorzelle 571 werden mit den Symbolen LO, LM, LU, MO, MU, RO, RM, RU bezeichnet, die die Positionen der acht Nachbarn nach dem folgenden Schema kennzeichnen:

| LO | MO | RO |
|----|----|----|
| LM | 1 | RM |
| LU | MU | RU |

Angenommen, von den betrachteten neun Deflektorzellen 571 werde nur die innere Deflektorzelle 571 angesteuert und bewirke die Ablenkung "1" für "seinen" Partikelteilstrahl 118 (engl.: Beamlet), dann ergibt sich infolge des Übersprechens auf die benachbarten acht Partikelteilstrahlen 118 eine Ablenkung der Größe $C_{LO}$, $C_{LM}$, $C_{LU}$, $C_{MO}$, $C_{MU}$, $C_{RO}$, $C_{RM}$, $CR_U$.

Die Größen $C_{LO}$, $C_{LM}$ usw. sind dann die Crosstalk-Koeffizienten. Sie sind im Falle eines Deflektorzellenarrays 57 aus regelmäßigen und baugleichen Deflektorzellen 571, 572 typisch kleiner als 5%. Sie können theoretisch durch geeignete Modellierung oder auch experimentell ermittelt werden.

Es wird ferner angenommen, dass diese Koeffizienten für alle inneren Deflektorzellen 571 gleich sind.

Eine innere Deflektorzelle 571 im oben betrachteten 10x10 Deflektorzellenarray 57 habe die unkorrigierte Ansteuerspannung $U_{ij}^0$. Die korrigierte Ansteuerspannung lautet dann:

$$\begin{aligned} U_{ij} = \quad & U_{ij}^0 - C_{RU} * U_{i-1,\,j-1}^0 - C_{MU} * U_{i-1,\,j}^0 - C_{LU} * U_{i-1,\,j+1}^0 \\ & - C_{RM} * U_{i,\,j-1}^0 - C_{LM} * U_{i,\,j+1}^0 \\ & - C_{RO} * U_{i+1,\,j-1}^0 - C_{MO} * U_{i+1,\,j}^0 - C_{LO} * U_{i+1,\,j+1}^0 \qquad i,\,j = 1\ldots8 \end{aligned}$$

Dabei wird (gemäß obiger Annahme 1) vernachlässigt, dass die Korrektur der Ansteuerspannung einer benachbarten Deflektorzelle 571 durch das Übersprechen auch auf die übernächste Deflektorzelle 571 bzw. 572 wirkt (Vernachlässigung von Effekten höherer Ordnung). Dies scheint deshalb erlaubt, da die Koeffizienten $C_{LO}$, $C_{LM}$ usw. betragsmäßig kleiner als 0,05 sind.

Bezugszeichenliste

| | |
|---|---|
| 1 | Partikelstrahlquelle |
| 10 | Strahlaustritt der Partikelstrahlquelle |
| 11 | Partikelstrahl |
| 110 | Zwischenbild des Strahlaustritts |
| 111 - 114 | Crossover |
| 115 | optische Achse |
| 116 | Austrittsaperturblende (der Partikelstrahlquelle) |
| 117 | Beleuchtungsgruppe zur Teilstrahlerzeugung |
| 118 | Partikelteilstrahl |
| 119 | Zwischenabbildung |
| | |
| 2 | Beleuchtungssystem |
| 21 | Beleuchtungsanpasskondensor |
| 22 | Beleuchtungsgruppenselektor |
| 23 | Beleuchtungsstigmator |
| 24 | Steuereinheit (für Beleuchtungsgruppenselektor) |
| | |
| 3 | Strahlmodulatorsystem |
| 31-32 | Kondensorsystem |
| 31 - 34 | Kondensorlinsen |
| 35 | Gruppenablenksystem (gesamt) |
| 351-353 | Gruppenablenksystem |
| 36 | Koppelmatrix-Rechenwerk |
| 37 | Crosstalk-Korrektur-Rechenwerk |
| 38 | Datenmultiplexer |
| | |
| 4 | Multiformatblendensystem |
| 41, 42 | erstes, zweites Multiformatblendenarray |
| 43 | Blendenplatte |
| 44 | Blendenöffnung |
| 45 | Strahlformblendengruppe |
| 46 | Charakter (spezielle Blendenstruktur) |
| 47 | Teilstrahlquerschnitt (vorgegeben vom Multiformatblendenarray 41) |

| 5 | Multistrahldeflektorsystem |
|---|---|
| 51, 52 | erstes, zweites Multistrahldeflektorarray |
| 53, 54 | drittes, viertes Multistrahldeflektorarray (Feinpositionierarray) |
| 55 | Deflektorchip |
| 56 | Deflektorchipausschnitt |
| 57 | Deflektorzellenarray |
| 571 | aktive Deflektorzelle |
| 572 | Dummy-Deflektorzelle |
| 573 | Elektrodenpaar |
| 574 | Abschirmelektrode |
| 58 | D/A-Wandler |
| 59 | Demultiplexer |

| 6 | Verkleinerungssystem |
|---|---|
| 60 | (zusätzliche) Verkleinerungslinse |
| 61-62 | Verkleinerungssystem |
| 63 | Strahlrückführsystem |
| 64 | Stigmator |
| 65 | Ablenksystem zur Strahlnachführung |
| 66 | Mikrostrahlablenksystem |
| 67 | Makrostrahlablenksystem |
| 68 | schnelle Fokussierlinse |
| 69 | Stigmator |

| 7 | Aperturblende |
|---|---|

| 8 | Substratüberwachungssensorik |
|---|---|
| 81 | Höhensensor |
| 82 | Rückstreu-Partikeldetektor |

| 9 | Tischsystem |
|---|---|
| 91 | Substrat |

## Patentansprüche

1. Anordnung zur Beleuchtung eines Substrates mit mehreren individuell geformten steuerbaren Partikelstrahlen (118) ausgestattet mit

   - einer Partikelstrahlquelle (1) zur Aussendung eines Partikelstrahls (11),
   - einem Beleuchtungssystem (2) zur Formung und Ablenkung des Partikelstrahls (11) für die Beleuchtung eines ersten Aperturblendenarrays, wobei das erste Aperturblendenarray ein Multiblendenarray zur Erzeugung von separaten Partikelteilstrahlen (118) ist,
   - einem zweiten Multiblendenarray, auf welches das erste Multiblendenarray mittels eines Kondensorlinsensystems (31-32) abgebildet ist und das unter Berücksichtigung des Abbildungsmaßstabes zum ersten Multiblendenarray angepasste Blendenöffnungen (44) aufweist, wobei
   - das erste und das zweite Multiblendenarray als Multiformatblendenarrays (41, 42) zur Erzeugung von Partikelteilstrahlen (118) mit unterschiedlichen Strahlquerschnitten ausgebildet sind, und
   - einem Multistrahldeflektorsystem (5) zur individuellen Strahlablenkung der separaten Partikelstrahlen (118) und einer wenigstens einstufigen Verkleinerungsoptik (6) zur verkleinerten Abbildung der vom zweiten Aperturblendenarray durchgelassenen Partikelteilstrahlen (118) auf ein Substrat (91), wobei
   - dem ersten Multiformatblendenarray (41) und dem zweiten Multiformatblendenarray (42) mindestens drei Multistrahldeflektorarrays (51, 52, 53) zur individuellen Ablenkung der Partikelteilstrahlen (118) eines Partikelteilstrahlarrays mit gleichen Strahlquerschnitten zugeordnet sind, von denen

       - mindestens ein erstes Multistrahldeflektorarray (51) zwischen dem ersten Multiformatblendenarray (41) und dem zweiten Multiformatblendenarray (42) angeordnet ist, um mittels einer individuellen Strahlablenkung der einzelnen Partikelteilstrahlen (118) unterschiedliche Querschnitte der Partikelteilstrahlen (118) nach dem zweiten Multiformatblendenarray (42) zu erzeugen, und
- mindestens ein zweites Multistrahldeflektorarray (52) in der Nähe des zweiten Multiformatblendenarrays (42) angeordnet ist, um einzelne Partikelteilstrahlen (118) individuell in partielle Crossover abzulenken oder an einer in einem nachgeordneten Crossover (112) angeordneten Austrittsaperturblende (7) gezielt auszutasten,

**dadurch gekennzeichnet, dass**

--mindestens ein drittes Multistrahldeflektorarray (53) dem zweiten Multiformatblendenarray (42) in einer Entfernung von 10-20 % des Abstandes zwischen Multiformatblendenarray (42) und Crossover (112) nachgeordnet ist, um unterschiedliche Positionen der Partikelteilstrahlen (118) auf dem Substrat (91) zu erzeugen.

2. Anordnung nach Anspruch 1, **dadurch gekennzeichnet, dass**
die Multistrahldeflektorarrays (51, 52, 53, 54) aus zwei übereinander liegenden Deflektorchips (55) zusammengesetzt sind, auf denen jeweils ein Deflektorzellenarray (57) aus gleichen Elektrodenpaaren (573) für die individuelle Ablenkung von einzelnen Partikelteilstrahlen (118) in gleicher Richtung lateral zur optischen Achse (115) vorhanden sind, wobei die Elektrodenpaare (573) der Deflektorzellenarrays (57) auf den zwei Deflektorchips (55) in zueinander im Wesentlichen orthogonalen Richtungen ausgerichtet sind.

3. Anordnung nach Anspruch 1, **dadurch gekennzeichnet, dass**
das im Strahlverlauf des Beleuchtungssystems (2) für den von der Partikelstrahlquelle (1) ausgesendeten Partikelstrahl (11) ein Beleuchtungsgruppenselektor (22) mit nachgeordnetem Stigmator (23) zur Auswahl einer Beleuchtungsgruppe (117) auf dem ersten Multiformatblendenarray (41) angeordnet ist.

4. Anordnung nach Anspruch 1, **dadurch gekennzeichnet, dass**
die Multiformatblendenarrays (41, 42) mindestens zwei große Blendenöffnungen (44) im Bereich von 30 $\mu$m bis 200 $\mu$m Kantenlänge zur Belichtung mit großformatigem Partikelstrahl und mindestens eine Strahlformblendengruppe (45) aus einer Vielzahl kleiner Blendenöffnungen (44) im Bereich von 5 $\mu$m bis 20 $\mu$m Kantenlänge aufweisen.

5. Anordnung nach Anspruch 4, **dadurch gekennzeichnet, dass**
die Multiformatblendenarrays (41, 42) unterschiedliche Strahlformblendengruppen (45) aufweisen, wobei mittels des Beleuchtungsgruppenselektors (22) des Beleuchtungssystems (2) eine von mehreren unterschiedlichen Strahlformungsblendengruppen (45) des ersten Multiformatblendenarrays (41) separat beleuchtbar sind, um verschieden dimensionierte Partikelstrahlen und Arrays von Partikelteilstrahlen (118) zu erzeugen.

6. Anordnung nach Anspruch 1, **dadurch gekennzeichnet, dass**
die Multistrahldeflektorarrays (51, 52, 53) zur individuellen Ablenkung der Partikelteilstrahlen (118) so angeordnet sind, dass das erste Multistrahldeflektorarray (51) dem ersten Multiformatblendenarray (41) nachgeordnet ist, das zweite Multistrahldeflektorarray (52) dem zweiten Multiformatblendenarray (42) vorgeordnet und das dritte Multistrahldeflektorarray dem zweiten Multiformatblendenarray (42) nachgeordnet ist.

7. Anordnung nach Anspruch 1, **dadurch gekennzeichnet, dass**
das erste Multistrahldeflektorarray (51) dem zweiten Multiformatblendenarray (42) vorgeordnet und das zweite und das dritte Multistrahldeflektorarray (52, 53) dem zweiten Multiformatblendenarray (42) nachgeordnet sind.

8. Anordnung nach Anspruch 6, **dadurch gekennzeichnet, dass**
das erste Multistrahldeflektorarray (51) in unmittelbarer Nähe dem ersten Multiformatblendenarray (41) nachgeordnet, das zweite Multistrahldeflektorarray (52) in unmittelbarer Nähe dem zweiten Multiformatblendenarray (42) vorgeordnet und das dritte Multistrahldeflektorarray (53) dem zweiten Multiformatblendenarray (42) in einer Entfernung von 10...20 % des Abstandes bis zum nächsten Crossover (112) nachgeordnet ist.

9. Anordnung nach Anspruch 6, **dadurch gekennzeichnet, dass**
das erste Multistrahldeflektorarray (51) in unmittelbarer Nähe dem zweiten Multiformatblendenarray (42) vorgeordnet, das zweite Multistrahldeflektorarray (52) in unmittelbarer Nähe dem zweiten Multiformatblendenarray (42) nachgeordnet und das dritte Multistrahldeflektorarray (53) dem zweiten Multistrahldeflektorarray (52) in einer Entfernung von 10...20% des Abstandes bis zum nächsten Crossover (112) nachgeordnet ist.

10. Anordnung nach Anspruch 6, **dadurch gekennzeichnet, dass**

das erste Multistrahldeflektorarray (51) in unmittelbarer Nähe dem ersten Multiformatblendenarray (41) nachgeordnet, das zweite Multistrahldeflektorarray (52) in unmittelbarer Nähe dem zweiten Multiformatblendenarray (42) nachgeordnet und das dritte Multistrahldeflektorarray (53) dem zweiten Multistrahldeflektorarray (52) in einer Entfernung von 10...20 % des Abstandes bis zum nächsten Crossover (112) nachgeordnet ist.

11. Anordnung nach Anspruch 1, **dadurch gekennzeichnet, dass**
zwischen dem dritten Multistrahldeflektorarray (53) und dem auf das Substrat (91) abbildenden Verkleinerungssystem (6) ein mindestens zweistufiger Stigmator (64) zur Korrektur der toleranzbedingten Verzeichnung angeordnet ist.

12. Anordnung nach Anspruch 10, **dadurch gekennzeichnet, dass**
das erste Multistrahldeflektorarray (51) in unmittelbarer Nähe dem ersten Multiformatblendenarray (42) nachgeordnet, das zweite Multistrahldeflektorarray (52) in unmittelbarer Nähe dem zweiten Multiformatblendenarray (42) vorgeordnet, das dritte Multistrahldeflektorarray (53) als ein erstes Feinpositionierarray in unmittelbarer Nähe dem zweiten Multiformatblendenarray (42) nachgeordnet sowie ein viertes Multistrahldeflektorarray (54) als ein zweites Feinpositionierarray dem dritten Multistrahldeflektorarray (53) nachgeordnet ist.

13. Anordnung nach Anspruch 2, **dadurch gekennzeichnet, dass**
die Elektrodenpaare (573) der Deflektorzellenarrays (57) auf den übereinanderliegenden Deflektorchips (55) orthogonal zueinander angeordnet sind.

14. Anordnung nach Anspruch 13, **dadurch gekennzeichnet, dass**
die Multistrahldeflektorarrays (51, 52, 53, 54) bei Verwendung einer Strahlformblendengruppe (45) in einem Array vom Format (n x m) auf jedem Deflektorchip (55) ein Deflektorzellenarray (57) mit mindestens (n+2) Zeilen und (m+2) Spalten von Deflektorzellen (571) aus parallelen Elektrodenpaaren (573) aufweisen, von denen die außen liegenden Deflektorzellen (572) ohne Spannungsbeaufschlagung sind.

15. Anordnung nach Anspruch 14, **dadurch gekennzeichnet, dass**
zur Kompensation des Übersprechens zwischen benachbarten Deflektorzellen (571) des Deflektorzellenarrays (57) Mittel zur Spannungsberechnung und - regelung vorgesehen sind, in denen zur Korrekturberechnung der Ablenkspannungen innerhalb eines Deflektorzellenarray (57) ausschließlich die Übersprechwirkung der jeweils acht direkt benachbarten Deflektorzellen (571) für jeden einzeln betrachteten Partikelteilstrahl (118) einbezogen ist.

16. Anordnung nach Anspruch 14, **dadurch gekennzeichnet, dass**
die Multistrahldeflektorarrays (51, 52, 53, 54) jeweils schnelle Pipelinestrukturen aus mehrkanaligen aktiven Bauelementen zur schnellen unabhängigen Steuerung der Strahlposition, der Querschnittsfläche und der individuellen Crossover-Position für jeden Partikelteilstrahl (118) aufweisen.

17. Anordnung nach Anspruch 16, **dadurch gekennzeichnet, dass**
die Multistrahldeflektorarrays (51, 52, 53, 54) jeweils schnelle Pipelinestrukturen aus Multi-DA-Wandler (58), Demultiplexern (59) und Mehrfach-Operationsverstärkern aufweisen.

18. Anordnung nach Anspruch 16, **dadurch gekennzeichnet, dass**
eine Koppelmatrix zur Steuerung des Multistrahldeflektorarrays (51, 52, 53, 54) vorgesehen ist, um eine unabhängige Steuerung der Position und Größe des Partikelteilstrahls (118) auf dem Substrat (91) sowie der individuellen Crossover-Position für jeden Partikelteilstrahl (118) eines Arrays von Partikelteilstrahlen (118) in X- und Y-Richtung zu erreichen.

19. Anordnung nach Anspruch 4, **dadurch gekennzeichnet, dass**
mindestens das zweite Multiformatblendenarray (42) zusätzlich spezielle Charaktere (46) zur Belichtung von Wiederholstrukturen aufweisen.

20. Anordnung nach Anspruch 4, **dadurch gekennzeichnet, dass**
die Multiformatblendenarrays (41, 42) mehrere verschiedene Strahlformblendengruppen (45) mit untereinander gleichen Blendenöffnungen (44) aufweisen.

21. Anordnung nach Anspruch 4, **dadurch gekennzeichnet, dass**
die Multiformatblendenarrays (41, 42) mehrere Strahlformblendengruppen (45) mit untereinander verschiedenen Blendenöffnungen (44) aufweisen.

**22.** Anordnung nach Anspruch 3, **dadurch gekennzeichnet, dass**

eine vorprogrammierbare Steuereinheit (24) zur Steuerung des Beleuchtungsgruppenselektors (22) mit nachgeordnetem Stigmator (23) für die optimierte Auswahl von Beleuchtungsgruppen (117) auf dem ersten Multiformatblendenarrays (41) vorhanden ist, um die Anzahl von Einzelbelichtungsschritten zu minimieren.

**Claims**

**1.** Arrangement for the illumination of a substrate with a plurality of individually shaped, controllable particle beams (118), equipped with

- a particle beam source (1) for emitting a particle beam (11),
- an illumination system (2) for shaping and deflecting the particle beam (11) for the illumination of a first aperture diaphragm array, wherein the aperture diaphragm array is a multiple-diaphragm array for generating separate particle beamlets (118),
- a second multiple-diaphragm array on which the first multiple-diaphragm array is imaged by means of a condenser lens system (31 - 32) and which has diaphragm apertures (44) which are adapted to the first multiple-diaphragm array while taking into account the imaging scale, wherein
- the first multiple-diaphragm array and the second multiple-diaphragm array are constructed as multiple-format diaphragm arrays (41, 42) for generating particle beamlets (118) with different beam cross sections, and
- a multibeam deflector system (5) for individual beam deflection of the separate particle beams (118), and reduction optics (6) having at least one stage for reduced imaging of the particle beamlets (118) passed by the second aperture diaphragm array onto a substrate (91), wherein
- at least three multibeam deflector arrays (51, 52, 53) for individual deflection of the particle beamlets (118) of a particle beamlet array with equal beam cross sections are associated with the first multiple-format diaphragm array (41) and with the second multiple-format diaphragm array (42), of which

- at least a first multibeam deflector array (51) is arranged between the first multiple-format diaphragm array (41) and the second multiple-format diaphragm array (42) in order to generate different cross sections of the particle beamlets (118) after the second multiple-format diaphragm array (42) by means of an individual beam deflection of the individual particle beamlets (118), and
- at least a second multibeam deflector array (52) is arranged in the vicinity of the second multiple-format diaphragm array (42) in order to deflect individual particle beamlets (118) individually in partial crossovers or to deliberately blank individual particle beamlets (118) at an outlet aperture diaphragm (7) arranged in a crossover (112) downstream,

**characterized in that**

- at least a third multibeam deflector array (53) is arranged downstream of the second multiple-format diaphragm array (42) at a distance of 10 - 20% of the distance between the multiple-format diaphragm array (42) and crossover (112) in order to generate different positions of the particle beamlets (118) on the substrate (91).

**2.** Arrangement according to claim 1, **characterized in that** the multibeam deflector arrays (51, 52, 53, 54) are composed of two deflector chips (55) which are arranged one on top of the other and on each of which is provided a deflector cell array (57) comprising identical pairs of electrodes (573) for the individual deflection of individual particle beamlets (118) in the same direction lateral to the optical axis (115), wherein the pairs of electrodes (573) of the deflector cell arrays (57) on the two deflector chips (55) are oriented in substantially orthogonal directions relative to one another.

**3.** Arrangement according to claim 1, **characterized in that** an illumination group selector (22) with a stigmator (23) arranged downstream is arranged in the beam path of the illumination system (2) for the particle beam (11) emitted by the particle beam source (1) for selecting an illumination group (117) on the first multiple-format diaphragm array (41).

**4.** Arrangement according to claim 1, **characterized in that** the multiple-format diaphragm arrays (41, 42) have at least two large diaphragm apertures (44) with an edge length in the range of 30 μm to 200 μm for exposure with large-format particle beam and at least one beam-shaping diaphragm group (45) comprising a plurality of small diaphragm apertures (44) with an edge length in the range of 5 μm to 20 μm.

5. Arrangement according to claim 4, **characterized in that** the multiple-format diaphragm arrays (41, 42) have different beam-shaping diaphragm groups (45), wherein one of a plurality of different beam-shaping diaphragm groups (45) of the first multiple-format diaphragm array (41) can be illuminated separately by means of the illumination group selector (22) of the illumination system (2) in order to generate differently dimensioned particle beams and arrays of particle beamlets (118).

6. Arrangement according to claim 1, **characterized in that** the multibeam deflector arrays (51, 52, 53) for individual deflection of the particle beamlets (118) are arranged in such a way that the first multibeam deflector array (51) is arranged behind the first multiple-format diaphragm array (41), the second multibeam deflector array (52) is arranged in front of the second multiple-format diaphragm array (42), and the third multibeam deflector array is arranged behind the second multiple-format diaphragm array (42).

7. Arrangement according to claim 1, **characterized in that** the first multibeam deflector array (51) is arranged in front of the second multiple-format diaphragm array (42), and the second multibeam deflector array (52) and third multibeam deflector array (53) are arranged behind the second multiple-format diaphragm array (42).

8. Arrangement according to claim 6, **characterized in that** the first multibeam deflector array (51) is arranged behind and in the immediate vicinity of the first multiple-format diaphragm array (41), the second multibeam deflector array (52) is arranged in front of and in the immediate vicinity of the second multiple-format diaphragm array (42), and the third multibeam deflector array (53) is arranged behind the second multiple-format diaphragm array (42) at a distance equal to 10% to 20% of the distance to the next crossover (112).

9. Arrangement according to claim 6, **characterized in that** the first multibeam deflector array (51) is arranged in front of and in the immediate vicinity of the second multiple-format diaphragm array (42), the second multibeam deflector array (52) is arranged behind and in the immediate vicinity of the second multiple-format diaphragm array (42), and the third multibeam deflector array (53) is arranged behind the second multibeam deflector array (52) at a distance equal to 10% to 20% of the distance to the next crossover (112).

10. Arrangement according to claim 6, **characterized in that** the first multibeam deflector array (51) is arranged behind and in the immediate vicinity of the first multiple-format diaphragm array (41), the second multibeam deflector array (52) is arranged behind and in the immediate vicinity of the second multiple-format diaphragm array (42), and the third multibeam deflector array (53) is arranged behind the second multibeam deflector array (52) at a distance equal to 10% to 20% of the distance to the next crossover (112).

11. Arrangement according to claim 1, **characterized in that** a stigmator (64) having at least two stages is arranged between the third multibeam deflector array (53) and the reduction system (6) imaging on the substrate (91) in order to correct for tolerance-dependent distortion.

12. Arrangement according to claim 10, **characterized in that** the first multibeam deflector array (51) is arranged behind and in the immediate vicinity of the first multiple-format diaphragm array (41), the second multibeam deflector array (52) is arranged in front of and in the immediate vicinity of the second multiple-format diaphragm array (42), the third multibeam deflector array (53), as a first precision positioning array, is arranged behind and in the immediate vicinity of the second multiple-format diaphragm array (42), and a fourth multibeam deflector array (54), as second precision positioning array, is arranged behind the third multibeam deflector array (53).

13. Arrangement according to claim 2, **characterized in that** the electrode pairs (573) of the deflector cell arrays (57) are arranged orthogonal to one another on the deflector chips (55) located one on top of the other.

14. Arrangement according to claim 13, **characterized in that** when a beam-shaping diaphragm group (45) is used in an array with a format (n x m), the multibeam deflector arrays (51, 52, 53, 54) have a deflector cell array (57) with at least (n+2) rows and (m+2) columns of deflector cells (571) of parallel electrode pairs (573) on every deflector chip (55), and no voltage is applied to the outside deflector cells (572).

15. Arrangement according to claim 14, **characterized in that** in order to compensate for crosstalk between adjacent deflector cells (571) of the deflector cell array (57), means for calculating voltage and regulating voltage are provided in which exclusively the crosstalk effect of the respective eight directly adjacent deflector cells (571) is taken into account for each particle beamlet (118) considered individually for calculating the correction of the deflection voltages within a deflector cell array (57).

16. Arrangement according to claim 14, **characterized in that** the multibeam deflector arrays (51, 52, 53, 54) have fast pipeline structures comprising multi-channel active components for fast independent control of the beam position, cross-sectional area, and individual crossover position for each particle beamlet (118).

17. Arrangement according to claim 16, **characterized in that** the multibeam deflector arrays (51, 52, 53, 54) have fast pipeline structures comprising multi-DA converters (58), demultiplexers (59), and multi-operational amplifiers.

18. Arrangement according to claim 16, **characterized in that** a coupling matrix is provided for controlling the multibeam deflector arrays (51, 52, 53, 54) in order to achieve an independent control of the position and size of the particle beamlet (118) on the substrate (91) and of the individual crossover position for each particle beamlet (118) of an array of particle beamlets (118) in the X-direction and Y-direction.

19. Arrangement according to claim 4, **characterized in that** at least the second multiple-format diaphragm array (42) has, in addition, special characters (46) for exposing repetitive structures.

20. Arrangement according to claim 4, **characterized in that** the multiple-format diaphragm arrays (41, 42) have a plurality of different beam-shaping diaphragm groups (45) with identical diaphragm apertures (44).

21. Arrangement according to claim 4, **characterized in that** the multiple-format diaphragm arrays (41, 42) have a plurality of beam-shaping diaphragm groups (45) with different diaphragm apertures (44).

22. Arrangement according to claim 3, **characterized in that** a pre-programmable control unit (24) is provided for controlling the illumination group selector (22) with stigmator (23) arranged downstream for the optimized selection of illumination groups (117) on the first multiple-format diaphragm array (41) in order to minimize the quantity of individual exposure steps.

## Revendications

1. Dispositif d'illumination d'un substrat avec plusieurs faisceaux de particules (118) réglables formés de manière individuelle, équipé de

   - une source de faisceaux de particules (1) pour émettre un faisceau de particules (11),
   - un système d'illumination (2) pour former et dévier le faisceau de particules (11) pour l'illumination d'un premier réseau de diaphragmes d'ouverture qui est un réseau multi-diaphragmes pour produire des faisceaux partiels de particules (118) séparés,
   - un deuxième réseau multi-diaphragmes sur lequel le premier réseau multi-diaphragmes est imagé au moyen d'un système de lentilles de condenseur (31 - 32) et qui a des ouvertures de diaphragmes (44) qui sont adaptées au premier réseau multi-diaphragmes en tenant compte de l'échelle de reproduction,
   - le premier réseau multi-diaphragmes et le deuxième réseau multi-diaphragmes étant réalisés sous la forme de réseaux de diaphragmes multiformat (41, 42) pour produire des faisceaux partiels de particules (118) avec des sections transversales de faisceau différentes, et
   - un système de déflecteur multifaisceaux (5) pour une déviation de faisceau individuelle des faisceaux de particules (118) séparés, et une optique de réduction (6) ayant au moins une étape pour l'imagerie réduite des faisceaux partiels de particules (118) passés par le deuxième réseau de diaphragmes d'ouverture sur un substrat (91),
   - au moins trois réseaux de déflecteur multifaisceaux (51, 52, 53) pour la déviation individuelle des faisceaux partiels de particules (118) d'un réseau de faisceaux partiels de particules avec des mêmes sections transversales de faisceau étant attribués au premier réseau de diaphragmes multiformat (41) et au deuxième réseau de diaphragmes multiformat (42), dont

   - au moins un premier réseau de déflecteur multifaisceaux (51) est disposé entre le premier réseau de diaphragmes multiformat (41) et le deuxième réseau de diaphragmes multiformat (42), pour produire des sections transversales différentes des faisceaux partiels de particules (118) après le deuxième réseau de diaphragmes multiformat (42) au moyen d'une déviation de faisceau individuelle des faisceaux partiels de particules (118) individuels, et
   - au moins un deuxième réseau de déflecteur multifaisceaux (52) est disposé à proximité du deuxième réseau de diaphragmes multiformat (42) pour dévier des faisceaux partiels de particules (118) individuels dans des croisements partiels de manière individuelle ou pour supprimer des faisceaux partiels de particules (118) individuels délibérément sur un diaphragme d'ouverture (7) de sortie disposé dans un croisement (112) en aval,

**caractérisé en ce qu'**

- au moins un troisième réseau de déflecteur multifaisceaux (53) est disposé en aval du deuxième réseau de diaphragmes multiformat (42) à une distance de 10 - 20% de la distance entre le réseau de diaphragmes multiformat (42) et le croisement (112), pour générer des positions différentes des faisceaux partiels de particules (118) sur le substrat (91).

2. Dispositif selon la revendication 1, **caractérisé en ce que** les réseaux de déflecteur multifaisceaux (51, 52, 53, 54) sont composés de deux puces de déflecteur (55) qui sont disposées l'une au-dessus de l'autre et sur lesquelles se trouve un réseau de cellules de déflecteur (57) comprenant des mêmes paires d'électrodes (573) pour la déviation individuelle de faisceaux partiels de particules (118) individuels dans la même direction latéralement à l'axe optique (115), les paires d'électrodes (573) des réseaux de cellules de déflecteur (57) sur les deux puces de déflecteur (55) étant orientées dans des directions essentiellement orthogonales les unes par rapport aux autres.

3. Dispositif selon la revendication 1, **caractérisé en ce qu'**un sélecteur de groupes d'illumination (22) avec un stigmateur (23) disposé en aval est disposé dans le trajet de faisceau du système d'illumination (2) pour le faisceau de particules (11) émis par la source de faisceaux de particules (1) pour sélectionner un groupe d'illumination (117) sur le premier réseau de diaphragmes multiformat (41).

4. Dispositif selon la revendication 1, **caractérisé en ce que** les réseaux de diaphragmes multiformat (41, 42) ont au moins deux grandes ouvertures de diaphragmes (44) avec une longueur des arêtes dans la plage de 30 $\mu$m à 200 $\mu$m pour l'exposition avec un faisceau de particules de grand format et au moins un groupe de diaphragmes à formation de faisceaux (45) comprenant une multitude de petites ouvertures de diaphragmes (44) avec une longueur des arêtes dans la plage de 5 $\mu$m à 20 $\mu$m.

5. Dispositif selon la revendication 4, **caractérisé en ce que** les réseaux de diaphragmes multiformat (41, 42) ont des groupes de diaphragmes de mise en forme de faisceaux (45) différents, un de plusieurs groupes de diaphragmes de mise en forme de faisceaux (45) différents du premier réseau de diaphragmes multiformat (41) pouvant être illuminé séparément au moyen du sélecteur de groupes d'illumination (22) du système d'illumination (2) pour générer des faisceaux de particules et des réseaux de faisceaux partiels de particules (118) dimensionnés de manière différente.

6. Dispositif selon la revendication 1, **caractérisé en ce que** les réseaux de déflecteur multifaisceaux (51, 52, 53) pour la déviation individuelle des faisceaux partiels de particules (118) sont disposés de telle manière que le premier réseau de déflecteur multifaisceaux (51) est disposé derrière le premier réseau de diaphragmes multiformat (41), le deuxième réseau de déflecteur multifaisceaux (52) est disposé devant le deuxième réseau de diaphragmes multiformat (42), et le troisième réseau de déflecteur multifaisceaux est disposé derrière le deuxième réseau de diaphragmes multiformat (42).

7. Dispositif selon la revendication 1, **caractérisé en ce que** le premier réseau de déflecteur multifaisceaux (51) est disposé devant le deuxième réseau de diaphragmes multiformat (42), et le deuxième réseau de déflecteur multifaisceaux (52) et le troisième réseau de déflecteur multifaisceaux (53) sont disposés derrière le deuxième réseau de diaphragmes multiformat (42).

8. Dispositif selon la revendication 6, **caractérisé en ce que** le premier réseau de déflecteur multifaisceaux (51) est disposé derrière et à proximité immédiate du premier réseau de diaphragmes multiformat (41), le deuxième réseau de déflecteur multifaisceaux (52) est disposé devant et à proximité immédiate du deuxième réseau de diaphragmes multiformat (42), et le troisième réseau de déflecteur multifaisceaux (53) est disposé derrière le deuxième réseau de diaphragmes multiformat (42) à une distance égale à 10% à 20% de la distance jusqu'au croisement (112) prochain.

9. Dispositif selon la revendication 6, **caractérisé en ce que** le premier réseau de déflecteur multifaisceaux (51) est disposé devant et à proximité immédiate du deuxième réseau de diaphragmes multiformat (42), le deuxième réseau de déflecteur multifaisceaux (52) est disposé derrière et à proximité immédiate du deuxième réseau de diaphragmes multiformat 42), et le troisième réseau de déflecteur multifaisceaux (53) est disposé derrière le deuxième réseau de déflecteur multifaisceaux (52) à une distance égale à 10% à 20% de la distance jusqu'au croisement (112) prochain.

10. Dispositif selon la revendication 6, **caractérisé en ce que** le premier réseau de déflecteur multifaisceaux (51) est disposé derrière et à proximité immédiate du premier réseau de diaphragmes multiformat (41), le deuxième réseau de déflecteur multifaisceaux (52) est disposé derrière et à proximité immédiate du deuxième réseau de diaphragmes multiformat (42), et le troisième réseau de déflecteur multifaisceaux (53) est disposé derrière le deuxième réseau de déflecteur multifaisceaux (52) à une distance égale à 10% à 20% de la distance jusqu'au croisement (112) prochain.

11. Dispositif selon la revendication 1, **caractérisé en ce qu'**un stigmateur (64) ayant au moins deux étapes est disposé entre le troisième réseau de déflecteur multifaisceaux (53) et le système de réduction (6) reproduisant un image sur le substrat (91) pour corriger de la distorsion due à la tolérance.

12. Dispositif selon la revendication 10, **caractérisé en ce que** le premier réseau de déflecteur multifaisceaux (51) est disposé derrière et à proximité immédiate du premier réseau de diaphragmes multiformat (41), le deuxième réseau de déflecteur multifaisceaux (52) est disposé devant et à proximité immédiate du deuxième réseau de diaphragmes multiformat (42), le troisième réseau de déflecteur multifaisceaux (53), comme un premier réseau de positionnement précis, est disposé derrière et à proximité immédiate du deuxième réseau de diaphragmes multiformat (42), et un quatrième réseau de déflecteur multifaisceaux (54), comme un deuxième réseau de positionnement précis, est disposé derrière le troisième réseau de déflecteur multifaisceaux (53).

13. Dispositif selon la revendication 2, **caractérisé en ce que** les paires d'électrodes (573) des réseaux de cellules de déflecteur (57) sont disposées orthogonalement les unes par rapport aux autres sur les puces de déflecteur (55) superposées.

14. Dispositif selon la revendication 13, **caractérisé en ce que** lors de l'utilisation d'un groupe de diaphragmes de mise en forme de faisceaux (45) dans un réseau d'un format de (n x m), les réseaux de déflecteur multifaisceaux (51, 52, 53, 54) ont un réseau de cellules de déflecteur (57) avec au moins (n+2) lignes et (m+2) colonnes de cellules de déflecteur (571) de paires d'électrodes (573) parallèles sur chaque puce de déflecteur (55), et aucun voltage n'est appliqué aux cellules de déflecteur (572) situées à l'extérieur.

15. Dispositif selon la revendication 14, **caractérisé en ce que** pour compenser la diaphonie entre les cellules de déflecteur (571) adjacentes du réseau de cellules de déflecteur (57) des moyens sont prévus pour calculer et régler le voltage, dans lesquels exclusivement l'effet de diaphonie des huit cellules de déflecteur (571) respectives directement adjacentes est pris en compte pour chaque faisceau partiel de particules (118) considéré individuellement pour calculer la correction des voltages de déviation dans un réseau de cellules de déflecteur (57).

16. Dispositif selon la revendication 14, **caractérisé en ce que** les réseaux de déflecteur multifaisceaux (51, 52, 53, 54) ont des structures de pipeline rapide comprenant des composants actifs multicanaux pour un contrôle indépendant et rapide de la position de faisceau, de la surface de la section transversale, et de la position de croisement individuelle pour chaque faisceau partiel de particules (118).

17. Dispositif selon la revendication 16, **caractérisé en ce que** les réseaux de déflecteur multifaisceaux (51, 52, 53, 54) ont des structures de pipeline rapide comprenant des convertisseurs multi-DA (58), des démultiplexeurs (59), et des amplificateurs multi-opérationnels.

18. Dispositif selon la revendication 16, **caractérisé en ce qu'**une matrice de couplage est prévue pour contrôler les réseaux de déflecteur multifaisceaux (51, 52, 53, 54) pour obtenir un contrôle indépendant de la position et du tailleur du faisceau partiel de particules (118) sur le substrat (91) et de la position de croisement individuelle pour chaque faisceau partiel de particules (118) d'un réseau de faisceaux partiels de particules (118) dans la direction X et la direction Y.

19. Dispositif selon la revendication 4, **caractérisé en ce qu'**au moins le deuxième réseau de diaphragmes multiformat (42) a, supplémentairement, des caractères (46) spéciaux pour exposer des structures répétitives.

20. Dispositif selon la revendication 4, **caractérisé en ce que** les réseaux de diaphragmes multiformat (41, 42) ont plusieurs groupes de diaphragmes de mise en forme de faisceaux (45) différents avec des ouvertures de diaphragmes (44) identiques.

21. Dispositif selon la revendication 4, **caractérisé en ce que** les réseaux de diaphragmes multiformat (41, 42) ont plusieurs groupes de diaphragmes de mise en forme de faisceaux (45) avec des ouvertures de diaphragmes (44) différentes.

22. Dispositif selon la revendication 3, **caractérisé en ce qu'**une unité de contrôle (24) pré-programmable est prévue pour contrôler le secteur de groupes d'illumination (22) avec un stigmateur (23) disposé en aval pour la sélection optimisée de groupes d'illumination (117) sur le premier réseau de diaphragmes multiformat (41) pour minimiser le nombre d'étapes d'exposition individuelle.

**Fig. 1**

**Fig. 2**

**Fig. 3a**

**Fig. 3b**

5n (n=1...4)

59   58   57   55   56   58   59

A-A

57   55   56

EP 2 197 014 B1

55

Fig. 5

56

56

57

56

56

**Fig. 4a**

55

57

56

56

571

572

56

**Fig. 4b**   572   571

**Fig. 5**

**Transformations-**
**koeffizienten** 36

**Crosstalk-**
**koeffizienten** 37

38

Sxi, Syi

SMxi, SMyi

**Individuelles**
**Austast-Signal**

Zum Demultiplexer
des Multideflektorchips
(Fig. 3)

**Individuelle Parameter**
**der Partikelteilstrahlen**

**Individuelle**
**Ablenkwerte**

**Korrigierte**
**Ablenkwerte**

**Highspeed-Datenstrom**
**der Ablenkwerte**

# Fig. 6

EP 2 197 014 B1

**Fig. 7a**

**Fig. 7b**

**Fig. 8**

**Fig. 9**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7005658 B2
- US 5981962 A
- US 6175122 B1
- US 6614035 B2
- DE 10020714 A1
- DD 241500 A1

**In der Beschreibung aufgeführte Nicht-Patentliteratur**

- **C. KLEIN et al.** Projection maskless lithography (PML2): proof-of-concept setup and first experimental results. *Proceedings SPIE Advanced Lithography,* 2008, vol. 6921, 93
- **E. SLOT et al.** MAPPER: high throughput maskless lithography. *Proceedings SPIE Advanced Lithography,* 2008, vol. 6921, 92